# EUROPEAN PATENT APPLICATION

(11) **EP 4 821 964 A1**
(43) Date of publication of application: **14.10.2026**
(21) Application number: 26166722.4
(22) Date of filing: 23.03.2026
(51) Int. Cl.: C08G 18/75, C08F 290/06, C08G 18/08, C08G 18/24, C08G 18/28, C08G 18/48, C08G 18/62, C08G 61/00, C08L 75/08, C08L 75/16, C09J 175/04, C09J 175/14

(54) **RESIN COMPOSITION, ADHESIVE MEMBER, AND ELECTRONIC APPARATUS INCLUDING THE ADHESIVE MEMBER**

(30) Priority: 07.04.2025 JP 2025062973
(71) Applicant: Samsung Display Co., Ltd., Yongin-si, Gyeonggi-do (KR)
(72) Inventor: INOUE, Naoto, Yokohama-shi, 220-0011 (JP)
(74) Representative: Marks & Clerk LLP

(57) **Abstract**

Provided is a resin composition including a urethane acrylate compound including a structure according to Chemical Formula 1, a monomer having one polymerizable unsaturated group per molecule, and a photopolymerization initiator. The urethane acrylate compound is contained in an amount of about 5% by weight to about 18% by weight based on the total weight of the resin composition, and the structure according to Chemical Formula 1 in the urethane acrylate compound is contained in an amount of about 20% by weight to about 60% by weight based on the total weight of the urethane acrylate compound.

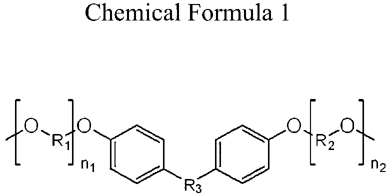

## Description

### BACKGROUND

### Field

The present disclosure relates to a resin composition, an adhesive member formed of the resin composition, and an electronic apparatus that includes the adhesive member.

### Description of Related Art

As devices with display screens such as televisions, mobile phones, tablet computers, navigation systems, and gaming consoles become more popular and a way of life, the development of these display devices continues to advance. These display devices incorporate various components including an adhesive member between the components. The adhesive member may be formed by providing a resin composition. Since the adhesive member is being used in multimedia devices, the adhesive member included in the display device should have characteristics that enable stable combination of the components in the display device and prevent deterioration of a display quality.

### SUMMARY

The present disclosure provides a resin composition having a low viscosity before curing and an increased adhesive strength after curing, an adhesive member formed of the resin composition, and an electronic apparatus including the adhesive member.

An embodiment of the inventive concept provides a resin composition including: a urethane acrylate compound including a structure according to Chemical Formula 1; a monomer having one polymerizable unsaturated group per molecule; and a photopolymerization initiator, wherein an amount of the urethane acrylate compound is about 5% by weight to about 18% by weight based on the total weight of the resin composition; and wherein an amount of the structure according to Chemical Formula 1 in the urethane acrylate compound is about 20% by weight to about 60% by weight based on the total weight of the urethane acrylate compound, 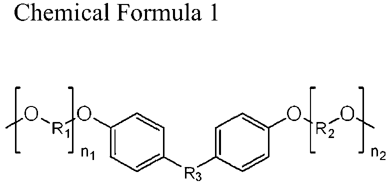 where, in Chemical Formula 1, R₁ and R₂ are each independently a substituted or unsubstituted alkylene group having 1 to 4 carbon atoms, R₃ is a substituted or unsubstituted alkylene group having 1 to 3 carbon atoms, and n₁ and n₂ are each independently an integer of 1 to 6.

In an embodiment, the resin may have a 180° peeling strength of about 2000 gram-force per 25 millimeter (gf/25 mm) to about 5000 gf/25 mm as measured at about 25 °C on a glass substrate after photocuring in air under an ultraviolet accumulated light quantity that is less than about 2000 millijoules per centimeter squared (mJ/cm²).

In an embodiment, the resin may have a 180° peeling strength of about 250 gf/25 mm to about 1000 gf/25 mm as measured at about 60 °C on a glass substrate may be after photocuring in air under an ultraviolet accumulated light quantity that is less than about 2000 mJ/cm².

In an embodiment, the urethane acrylate compound may be synthesized from a reactant that includes a first polyfunctional alcohol including the structure according to Chemical Formula 1, a second alcohol different from the first polyfunctional alcohol, a polyfunctional isocyanate-based compound, and a compound having at least one (meth)acryloyl group and at least one hydroxyl group per molecule.

In an embodiment, the second alcohol may include 2,2-bis(hydroxymethyl)butyric acid.

In an embodiment, the polyfunctional isocyanate-based compound may include 1,3-bis(isocyanatomethyl)cyclohexane.

In an embodiment, the polymerizable unsaturated group of the monomer may be an acrylate group.

In an embodiment, the monomer may include at least one of 4-hydroxybutyl acrylate, tetrahydrofurfuryl acrylate, isobornyl acrylate, isodecyl acrylate, dicyclopentenyl acrylate, lauryl acrylate (C12), 2-ethylhexyl acrylate, and 2-{2-[(2-ethylhexyl)oxy]ethoxy}ethyl acrylate.

In an embodiment, an amount of the monomer may be about 50% by weight to about 93% by weight based on the total weight of the resin composition.

In an embodiment, the urethane acrylate compound may have a weight-average molecular weight of about 3000 grams per mole (g/mol) to about 15000 g/mol.

In an embodiment, the photopolymerization initiator may include at least one of bis(2,4,6-trimethylbenzoyl)phenyl phosphine oxide, α-hydroxy alkyl phenone, ethyl(2,4,6-trimethylbenzoyl)phenyl phosphinate, and 1-hydroxy cyclohexyl-phenylketone.

In an embodiment, the resin composition may be provided through an inkjet printing method or a dispensing method.

In an embodiment of the inventive concept, an adhesive member includes: a polymer derived from a resin composition, wherein the resin composition includes a urethane acrylate compound including a structure according to Chemical Formula 1, a monomer having one polymerizable unsaturated group per molecule, and a photopolymerization initiator, wherein an amount of the urethane acrylate compound is about 5% by weight to about 18% by weight based on the total weight of the resin composition, and wherein an amount of the structure according to Chemical Formula 1 in the urethane acrylate compound is about 20% by weight to about 60% by weight based on the total weight of the urethane acrylate compound, 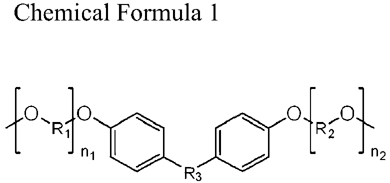 where, in Chemical Formula 1, R₁ and R₂ are each independently a substituted or unsubstituted alkylene group having 1 to 4 carbon atoms, R₃ is a substituted or unsubstituted alkylene group having 1 to 3 carbon atoms, and n₁ and n₂ are each independently an integer of 1 to 6.

In an embodiment, the polymer may have a 180° peeling strength of about 2000 gf/25 mm to about 5000 gf/25 mm as measured at about 25 °C on a glass substrate.

In an embodiment, the polymer may have a 180° peeling strength of about 250 gf/25 mm to about 1000 gf/25 mm as measured at about 60 °C on a glass substrate.

In an embodiment of the inventive concept, an electronic apparatus includes: a display device comprising a display module and a window and an adhesive member disposed between the display module and the window; wherein: the display device provides an image, the adhesive member includes a polymer derived from a resin composition, wherein the resin composition includes a urethane acrylate compound including a structure according to Chemical Formula 1, a monomer having one polymerizable unsaturated group per molecule, and a photopolymerization initiator, wherein an amount of the urethane acrylate compound is about 5% by weight to about 18% by weight based on the total weight of the resin composition, and wherein an amount of the structure according to Chemical Formula 1 in the urethane acrylate compound is about 20% by weight to about 60% by weight based on the total weight of the urethane acrylate compound, 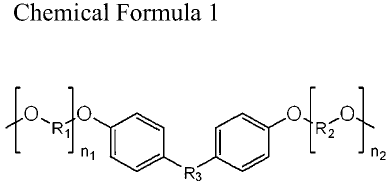 where, in Chemical Formula 1, R₁ and R₂ are each independently a substituted or unsubstituted alkylene group having 1 to 4 carbon atoms, R₃ is a substituted or unsubstituted alkylene group having 1 to 3 carbon atoms, and n₁ and n₂ are each independently an integer of 1 to 6.

In an embodiment, the adhesive member may have a 180° peeling strength of about 2000 gf/25 mm to about 5000 gf/25 mm, as measured at about 25 °C on a glass substrate, and a 180° peeling strength of about 250 gf/25 mm to about 1000 gf/25 mm, as measured at about 60°C on a glass substrate.

In an embodiment, the window may include a base layer and a printed layer disposed between the adhesive member and the base layer, and the resin composition provided on one surface of the display module or one surface of the window may be cured by being irradiated with light which passes through the printed layer, and the adhesive member may be formed.

In an embodiment, the display device may include a display module, a processor, a memory, and a power module.

At least some of the above and other features of the invention are set out in the claims.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a block diagram of an electronic apparatus according to an embodiment;
FIG. 2 is a schematic view of each of electronic apparatuses according to various embodiments;
FIG. 3 is a perspective view illustrating an electronic apparatus according to an embodiment;
FIG. 4 is an exploded perspective view illustrating a display device according to an embodiment;
FIG. 5 is a cross-sectional view taken along line I-I' of FIG. 4;
FIG. 6 is a cross-sectional view illustrating a part of a display device according to an embodiment;
FIG. 7A is a view illustrating a method for manufacturing an adhesive member according to an embodiment;
FIG. 7B is a view illustrating a method for manufacturing an adhesive member according to an embodiment;
FIG. 7C is a view illustrating a method for manufacturing an adhesive member according to an embodiment;
FIG. 7D is a view illustrating a method for manufacturing an adhesive member according to an embodiment;
FIG. 8A is a view illustrating a method for manufacturing an adhesive member according to an embodiment;
FIG. 8B is a view illustrating a method for manufacturing an adhesive member according to an embodiment;
FIG. 8C is a view illustrating a method for manufacturing an adhesive member according to an embodiment;
FIG. 9 is a cross-sectional view illustrating a display device according to an embodiment; and
FIG. 10 is a cross-sectional view illustrating a display device according to an embodiment.

### DETAILED DESCRIPTION

The inventive concept may be implemented in various modifications and have various forms, and specific embodiments are illustrated in the drawings and described in detail in the text. It is to be understood, however, that the inventive concept is not intended to be limited to the particular forms disclosed, but on the contrary, is intended to cover all modifications, equivalents, and alternatives falling within the scope of the inventive concept.

In this specification, it will be understood that when an element (or a region, a layer, a portion, or the like) is referred to as being "on", "connected to" or "coupled to" another element, it may be directly disposed on, connected to, or coupled to the other element, or other elements may be disposed therebetween.

Like reference numerals or symbols refer to like elements throughout. In the drawings, the thickness, ratio, and size of the elements are exaggerated for effectively describing the technical contents. As used herein, the term "and/or" includes any and all combinations of one or more of the associated listed elements.

It will be understood that, although the terms "first", "second", etc. may be used herein to describe various elements, the elements are not to be limited by these terms. These terms are only used to distinguish one element, component, region, layer or section from another element, component, region, layer or section. For instance, a first element, component, region, layer or section discussed below could be termed a second element, component, region, layer or section without departing from the scope of the inventive concept. Similarly, a second element, component, region, layer or section could be termed a first element, component, region, layer or section. In this specification, the singular expressions "a", "an" and "the" are intended to include the plural forms as well, unless the context clearly indicates otherwise.

In addition, the terms "below", "under", "on the lower side", "above", "over", "on the upper side", or the like may be used to describe the relationships between the elements illustrated in the drawings. These terms are relative concepts and are described on the basis of the directions indicated in the drawings. It will be understood that when an element is referred to as being "on" another element, it can be directly in contact with the other element or intervening elements may be present therebetween. In contrast, when an element is referred to as being "directly on" another element, there are no intervening elements present.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, a resin composition according to an embodiment of the inventive concept, an adhesive member according to an embodiment, and an electronic apparatus including the same will be described. A display device according to an embodiment may be applied to various electronic apparatuses. The electronic apparatus according to an embodiment may include the display device, and further include a module or a device which has additional functions in addition to the display device. "About" or "approximately" as used herein is inclusive of the stated value and means within an acceptable range of deviation for the particular value as determined by one of ordinary skill in the art, considering the measurement in question and the error associated with measurement of the particular quantity *(i.e.,* the limitations of the measurement system). For example, "about" can mean within one or more standard deviations, or within ± 20%, 10%, 5% of the stated value.

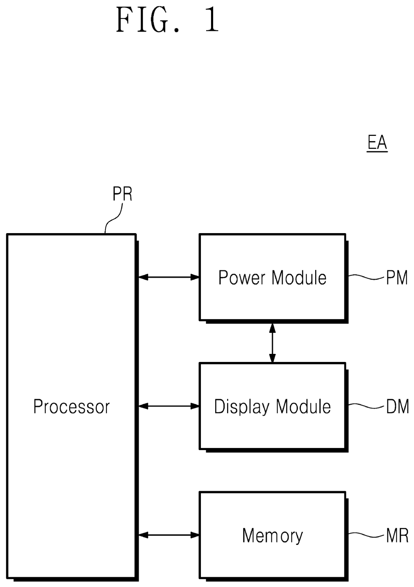

FIG. 1 is a block diagram of an electronic apparatus according to an embodiment. Referring to FIG. 1, an electronic apparatus EA according to an embodiment may include a display module DM, a processor PR, a memory MR, and a power module PM.

The processor PR may include at least one of a central processing unit (CPU), an application processor (AP), a graphic processing unit (GPU), a communication processor (CP), an image signal processor (ISP), and a controller.

The memory MR may store data information required for an operation of the processor PR or the display module DM. When the processor PR executes an application stored in the memory MR, image data signals and/or input control signals are transmitted to the display module DM, and the display module DM may process the transmitted signals and output image information through a display screen.

The power module PM may include a power supply module, such as a power adapter or a battery device, and a power conversion module which converts a power supplied from the power supply module to generate a power required for an operation of the electronic apparatus EA.

At least one of components of the above-described electronic apparatus EA may be included in the display device according to the above-described embodiments. Additionally, some of the individual modules which are functionally included in one module may be included in the display device and other modules may also be provided separately from the display device. For example, the display device includes the display module DM, and the processor PR, the memory MR, and the power module PM may be provided in a form of other devices in the electronic apparatus EA other than the display device.

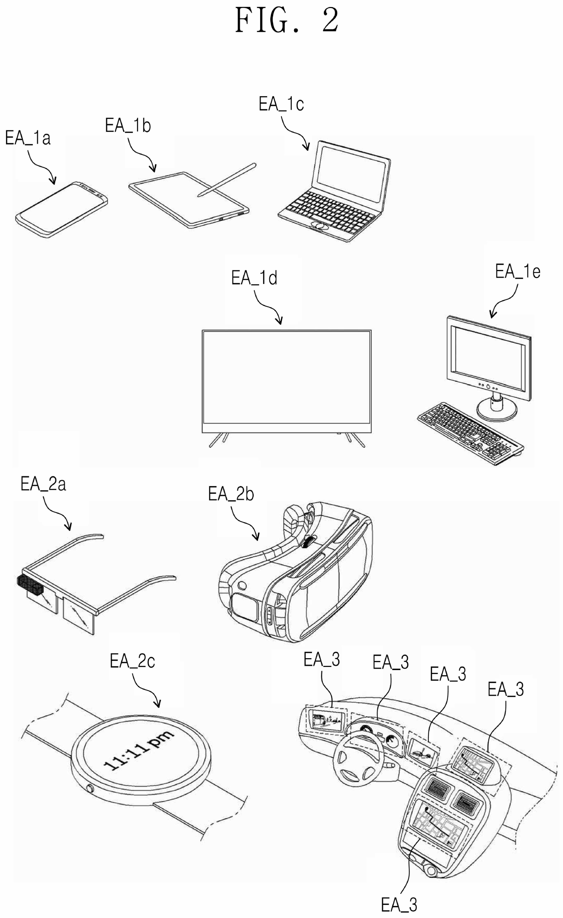

FIG. 2 is a schematic view of each of electronic apparatuses according to various embodiments. Referring to FIG. 2, various electronic apparatuses to which the display device according to embodiments is applied may include an electronic apparatus for displaying images, such as a smart phone EA_1a, a tablet computer EA_1b, a laptop computer EA_1c, a television EA_1d, a desktop monitor EA_1e, and a wearable electronic apparatus including the display module, such as smart glasses EA_2a, a head mounted display EA_2b, a smart watch EA_2c, as well as an automobile electronic apparatus EA_3 including the display module, such as a center information display (CID) disposed on an instrument panel, a center fascia, or a dashboard of a car, and a room mirror display.

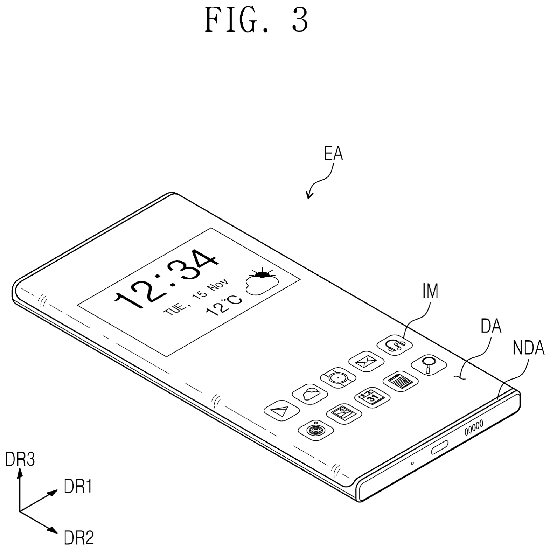

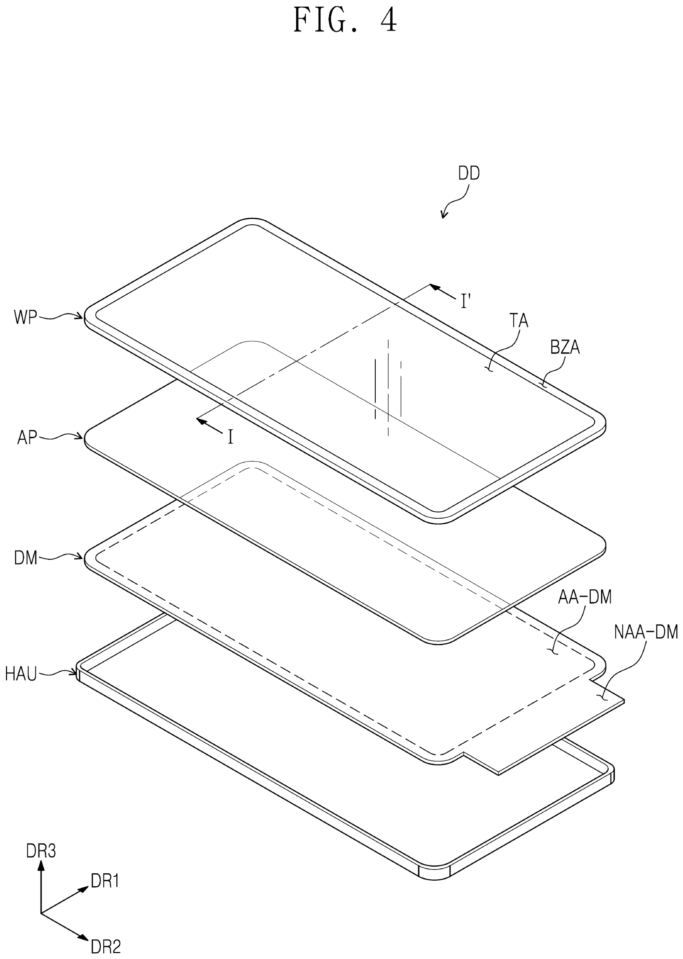

FIG. 3 is a perspective view illustrating an electronic apparatus according to an embodiment. FIG. 4 is an exploded perspective view of a display device according to an embodiment.

An electronic apparatus EA, according to an embodiment, which is illustrated in FIG. 3 may be activated in response to an electrical signal. In FIG. 3, the electronic apparatus EA is exemplarily illustrated as a smart phone.

The electronic apparatus EA according to an embodiment may display an image IM through a display region DA. The display region DA may include a flat surface defined by a first direction axis DR1 and a second direction axis DR2. The display region DA may include a curved surface bent from at least one side of the flat surface defined by the first direction axis DR1 and the second direction axis DR2. FIG. 3 illustrates that the electronic apparatus EA according to an embodiment includes two curved surfaces which are respectively bent from both sides of the flat surface defined by the first direction axis DR1 and the second direction axis DR2. However, the display region DA is not limited to a shape. For example, the display region DA may include only the flat surface defined by the first direction axis DR1 and the second direction axis DR2, as well as may further include at least two or more curved surfaces, for example, four curved surfaces respectively bent from four side surfaces of the flat surface defined by the first direction axis DR1 and the second direction axis DR2.

The electronic apparatus EA according to an embodiment may be flexible. The term "flexible" means a bendable property, and may include all of a completely foldable structure as well as a structure which is bendable to the level of several nanometers. For example, the electronic apparatus EA may be a foldable apparatus. Additionally, the electronic apparatus EA may be rigid.

A non-display region NDA may be adjacent to the display region DA. The non-display region NDA may surround the display region DA. Accordingly, a shape of the display region DA may be substantially defined by the non-display region NDA. However, this is presented as an example. The non-display region NDA may either be disposed to be adjacent to only one side of the display region DA or be omitted. The display region DA may be provided to have various shapes, and is not limited to any one embodiment.

In FIG. 3 and the following drawings, the first direction axis DR1 to a third direction axis DR3 are illustrated, and directions indicated by the first to third direction axes DR1, DR2, and DR3 described herein have a relative concept and thus may be changed to other directions. In addition, the directions indicated by the first to third direction axes DR1, DR2, and DR3 may be referred to as first to third directions, and may be denoted as the same reference numerals or symbols. In this specification, the first direction axis DR1 may be perpendicular to the second direction axis DR2, and the third direction axis DR3 may be a normal direction of the plane defined by the first direction axis DR1 and the second direction axis DR2.

A thickness direction of the electronic apparatus EA may be parallel to the third direction axis DR3 which is the normal direction of the plane defined by the first direction axis DR1 and the second direction axis DR2. In this specification, a front surface (or an upper surface, a top surface, an upper side) and a rear surface (or a lower surface, a bottom surface, a lower side) of each member constituting the electronic apparatus EA may be defined on the basis of the third direction axis DR3. In this specification, a direction in which the third direction axis DR3 extends is parallel to a thickness direction. The front surface (or the upper surface, the top surface, the upper side) means a surface (or a direction) adjacent to a surface on which an image IM is displayed, and the rear surface (or the lower surface, the bottom surface, the lower side) means a surface (or a direction) spaced apart from a surface on which the image IM is displayed. In this specification, a plane means a surface parallel to a plane defined by the first direction axis DR1 and the second direction axis DR2, and a cross section means a surface which is perpendicular to the plane defined by the first direction axis DR1 and the second direction axis DR2 and is parallel to the third direction axis DR3.

FIG. 4 is an exploded perspective view of a display device according to an embodiment. A display device DD according to an embodiment, which is illustrated in FIG. 4 may be included in the electronic apparatus EA according to an embodiment, which is illustrated in FIG. 3.

Referring to FIG. 4, the display device DD according to an embodiment may include a display module DM, a window WP disposed on the display module DM, and an adhesive member AP disposed between the display module DM and the window WP. Additionally, the display device DD may further include a housing HAU which accommodates the display module DM.

In the display device DD illustrated in FIG. 4, the window WP and the housing HAU may be coupled to constitute the exterior of the display device DD. The housing HAU may be disposed below the display module DM. The housing HAU may include a material having relatively higher rigidity. For example, the housing HAU may include a plurality of frames and/or plates formed of glass, plastic, or metal. The housing HAU may provide an accommodation space. The display module DM may be accommodated inside the accommodation space and protected against an external impact.

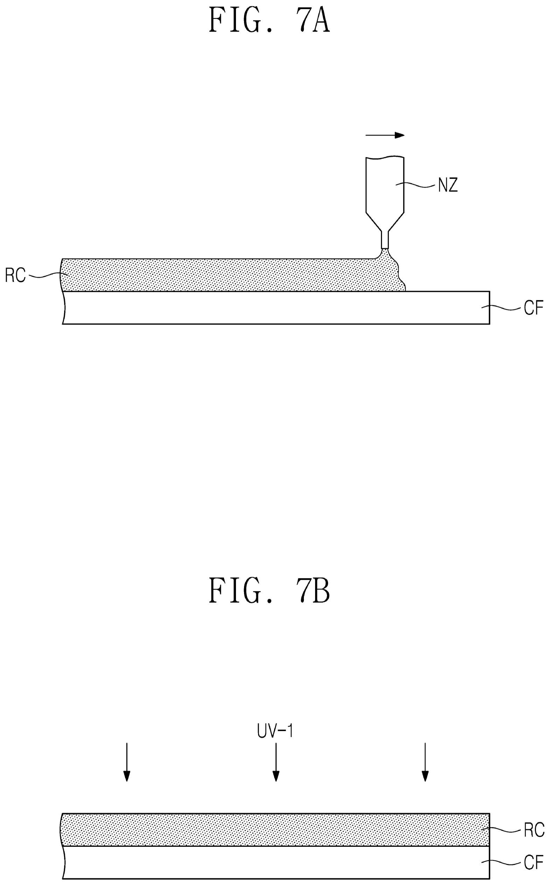

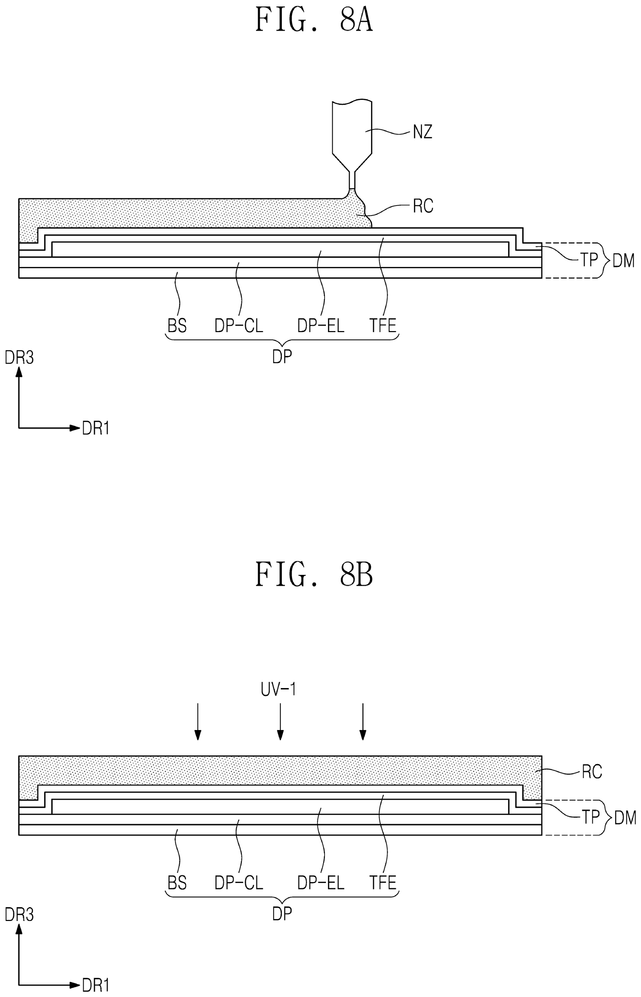

In an embodiment, the adhesive member AP includes a polymer derived from a resin composition RC (see FIGS. 7A and 8A). The adhesive member AP may be formed by photocuring the resin composition RC (see FIGS. 7A and 8A). The adhesive member AP may bond the display module DM and the window WP. The adhesive member AP according to an embodiment is formed of the resin composition RC (see FIGS. 7A and 8A) according to an embodiment and may thus exhibit an excellent adhesion reliability. Additionally, the adhesive member AP according to an embodiment may be prevented from discoloring due to external light (for example, ultraviolet rays).

The window WP may include a transmission region TA and a bezel region BZA. The transmission region TA may overlap at least a portion of an active region AA-DM of the display module DM. The transmission region TA may be an optically transparent region. The image IM (see FIG. 3) may be provided to a user through the transmission region TA.

The bezel region BZA may be a region having a relatively lower light transmittance than the transmission region TA. The bezel region BZA may define a shape of the transmission region TA. The bezel region BZA may be adjacent to the transmission region TA and surround the transmission region TA.

The bezel region BZA may have a color. The bezel region BZA may cover a peripheral region NAA-DM of the display module DM and block the peripheral region NAA-DM from being viewed from the outside. However, an embodiment is not limited to what is illustrated. The bezel region BZA may be disposed adjacent to only one side of the transmission region TA, or at least a portion thereof may be omitted.

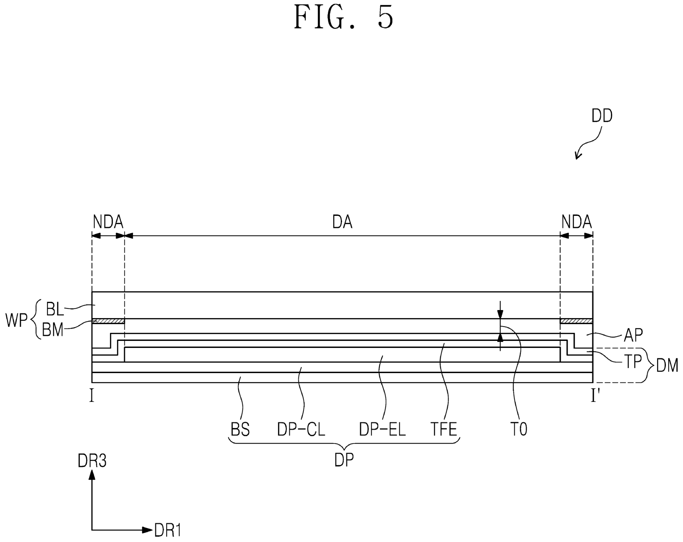

FIG. 5 is a cross-sectional view taken along line I-I' of FIG. 4. FIG. 5 is a cross-sectional view of a display device according to an embodiment, which includes the display module DM, the adhesive member AP, and the window WP in FIG. 4.

Referring to FIG. 5, the display module DM may include a display panel DP and an input-sensing part TP disposed on the display panel DP. The display panel DP may be configured to substantially generate an image. The display panel DP may include a base substrate BS, a circuit layer DP-CL disposed on the base substrate BS, a display element layer DP-EL disposed on the circuit layer DP-CL, and an encapsulation layer TFE covering the display element layer DP-EL. The adhesive member AP may be disposed between the display module DM and the window WP. When the display module DM includes the display panel DP and the input-sensing part TP, the adhesive member AP may be disposed between the window WP and the input-sensing part TP disposed on the display panel DP.

The components of the display panel DP illustrated in FIG. 5, etc. are illustrated as examples, and components of the display panel DP are not limited thereto. For example, the display panel DP may include a liquid crystal display element, and in this case, the encapsulation layer TFE may be omitted.

The base substrate BS may provide a base surface on which the circuit layer DP-CL is disposed. The base substrate BS may be a flexible substrate which is bendable, foldable, rollable, etc. The base substrate BS may be a glass substrate, a metal substrate, a polymer substrate, etc. However, an embodiment is not limited thereto, and the base substrate BS may include an inorganic layer, an organic layer, or a composite material layer.

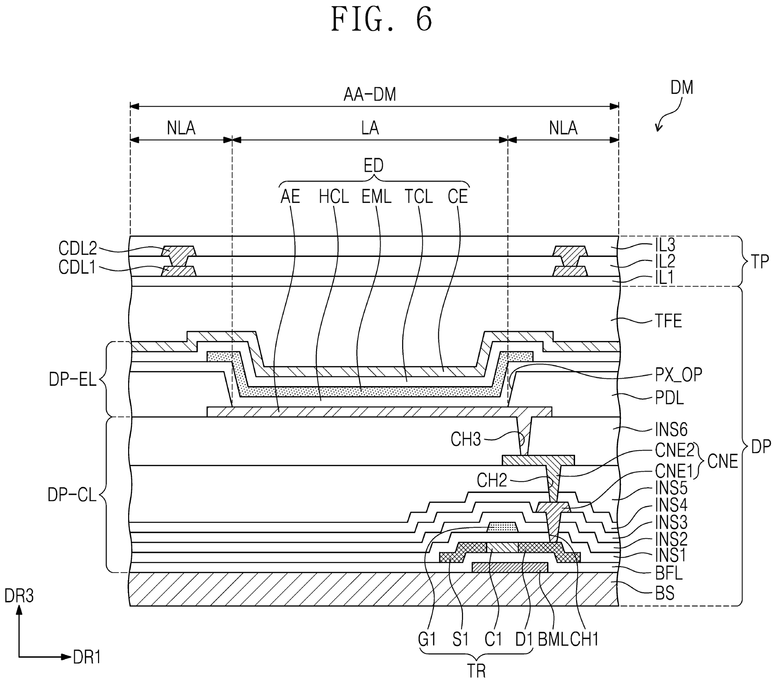

The circuit layer DP-CL may include an insulating layer, a semiconductor pattern, a conductive pattern, a signal line, etc. For example, the circuit layer DP-CL may include a switching transistor or a driving transistor for driving the light-emitting element ED (see FIG. 6) of the later-described display element layer DP-EL.

The display element layer DP-EL may include a light-emitting element ED (see FIG. 6) which emits light. For example, the light-emitting element ED (see FIG. 6) may include an organic light-emitting material, an inorganic light-emitting material, an organic-inorganic light-emitting material, quantum dots, quantum rods, a micro LED, or a nano LED.

The encapsulation layer TFE may be disposed on the display element layer DP-EL. The encapsulation layer TFE may protect the display element layer DP-EL against moisture, oxygen, and/or foreign substances such as dust particles. The encapsulation layer TFE may include at least one inorganic layer. For example, the encapsulation layer TFE may include an inorganic layer, an organic layer, and an inorganic layer which are sequentially stacked.

The input-sensing part TP may be disposed on the display panel DP. For example, the input-sensing part TP may be directly disposed on the encapsulation layer TFE of the display panel DP. Alternatively, an adhesive layer may also be disposed between the input-sensing part TP and the display panel DP.

In this specification, when an element is referred to as being directly disposed/provided on another element, there are no intervening elements therebetween. That is, the wording, "an element is 'directly disposed/provided on' another element" means that an element is "in contact with" another element.

The input-sensing part TP may detect an external input, change the detected external input to an input signal, and provide the input signal to the display panel DP. For example, in the display device DD according to an embodiment, the input-sensing part TP may be a touch-sensing part which detects a touch. The input-sensing part TP may recognize a direct touch by a user, an indirect touch by a user, a direct touch by an object, an indirect touch by an object, etc.

The input-sensing part TP may detect at least one of a position and intensity (pressure) of a touch applied from the outside. In an embodiment, the input-sensing part TP may have various structures or be composed of various materials, but is not limited to any one embodiment. For example, the input-sensing part TP may detect an external input in a capacitive manner. The display panel DP may receive the input signal from the input-sensing part TP and generate an image corresponding to the input signal.

The window WP may include a base layer BL and a printed layer BM. Although not illustrated, the window WP may further include at least one functional layer (not illustrated) provided on the base layer BL. For example, the functional layer (not illustrated) may be a hard coating layer, an anti-fingerprint coating layer, etc., but an embodiment is not limited thereto.

The base layer BL may be a glass substrate. Alternatively, the base layer BL may be a plastic substrate. For example, the base layer BL may be formed of polyimide, polyacrylate, polymethylmethacrylate, polycarbonate, polyethylenenaphthalate, polyvinylidene chloride, polyvinylidene difluoride, polystyrene, an ethylene vinylalcohol copolymer, or a combination thereof.

The printed layer BM may be disposed on one surface of the base layer BL. The printed layer BM may be provided on a lower surface of the base layer BL adjacent to the display module DM. The printed layer BM may be disposed in an edge region of the base layer BL. The printed layer BM may be an ink printed layer. Additionally, the printed layer BM may be a layer formed of a pigment or a dye. The printed layer BM may be formed of a light-absorbing material, or be formed of a black pigment or a black dye. However, this is presented as an example, and an embodiment is not limited thereto. In the window WP, the bezel region BZA (see FIG. 4) may be a part to which the printed layer BM is provided.

A thickness T0 of the adhesive member AP may be about 50 µm to about 300 µm. For example, the adhesive member AP may have the thickness T0 of about 50 µm to about 250 µm. However, this is presented as an example, and the thickness T0 of the adhesive member AP is not limited thereto.

FIG. 6 is a detailed cross-sectional view illustrating a display module DM according to FIG. 5. The components of the display module DM illustrated in FIG. 6 are illustrated as examples, and an embodiment is not limited thereto.

Referring to FIG. 6, a base substrate BS may include a single layer or a plurality of layers. For example, the base substrate BS may include a first synthetic resin layer, a multi- or single-layered inorganic layer, or a second synthetic resin layer disposed on the multi- or single-layered inorganic layer. The first synthetic resin layer and the second synthetic resin layer may each include a polyimide-based resin. Additionally, the first synthetic resin layer and the second synthetic resin layer may each include at least one of an acryl-based resin, a methacryl-based resin, a polyisoprene-based resin, a vinyl-based resin, an epoxy-based resin, a urethane-based resin, a cellulose-based resin, a siloxane-based resin, a polyamide-based resin, and a perylene-based resin. In this specification, the functional group proceeding the term "-base resin" is considered to be included within that base resin. For example, a "siloxane-based resin" will include the functional group siloxane.

A display panel DP may include a transistor TR and a light-emitting element ED. The transistor TR and the light-emitting element ED may be disposed on the base substrate BS. FIG. 6 illustrates one transistor TR, but the display panel DP may substantially include at least one capacitor and a plurality of transistors for driving the light-emitting element ED.

The circuit layer DP-CL may be disposed on the base substrate BS. The circuit layer DP-CL may include a shielding electrode BML, the transistor TR, a connection electrode CNE, and a plurality of insulating layers BFL and INS1 to INS6. The plurality of insulating layers BFL and INS1 to INS6 may include a buffer layer BFL and first to sixth insulating layers INS1 to INS6. However, the stacked structure of the circuit layer DP-CL illustrated in FIG. 6 is presented as an example, and a stacked structure of the circuit layer DP-CL may be changed according to a configuration of the display panel DP and processes for the circuit layer DP-CL, etc.

A shielding electrode BML may be disposed on the base substrate BS. The shielding electrode BML may overlap the transistor TR. The shielding electrode BML may block light incident onto the transistor TR from below the display panel DP to protect the transistor TR. The shielding electrode BML may include a conductive material. When a voltage is applied to the shielding electrode BML, a threshold voltage of the transistor TR disposed on the shielding electrode BML may be maintained. However, an embodiment is not limited thereto, and the shielding electrode BML may be a floating electrode. The shielding electrode BML may also be omitted.

The buffer layer BFL may be disposed on the base substrate BS and cover the shielding electrode BML. The buffer layer BFL may include an inorganic layer. The buffer layer BFL may improve a bonding force between the base substrate BS and a semiconductor pattern or a conductive pattern, which is disposed on the buffer layer BFL.

The transistor TR may include a source S1, a channel C1, a drain D1, and a gate G1. The source S1, the channel C1, and the drain D1 of the transistor TR may be formed from a semiconductor pattern. The semiconductor pattern of the transistor TR may include polysilicon, amorphous silicon, or a metal oxide. However, any material having semiconductor properties may be used without limitation, and the material is not limited to any one embodiment.

The semiconductor pattern may include a plurality of regions divided according to a conductivity level. In the semiconductor pattern, a region, which is doped with a dopant or in which a metal oxide is reduced, may have a high conductivity, and may serve substantially as a source electrode and a drain electrode of the transistor TR. A highly conductive region of the semiconductor pattern may correspond to the source S1 and the drain D1 of the transistor TR. In the semiconductor pattern, a region, which is undoped or lightly doped or which has a low conductivity due to a nonreduced metal oxide, may correspond to the channel C1 (or an active) of the transistor TR.

The first insulating layer INS1 may cover the semiconductor pattern of the transistor TR and be disposed on the buffer layer BFL. The gate G1 of the transistor TR may be disposed on the first insulating layer INS1. On a plane, the gate G1 may overlap the channel C1 of the transistor TR. The gate G1 may function as a mask during the process of doping the semiconductor pattern of the transistor TR.

The second insulating layer INS2 may cover the gate G1 and be disposed on the first insulating layer INS1. The third insulating layer INS3 may be disposed on the second insulating layer INS2.

The connection electrode CNE may include a first connection electrode CNE1 and a second connection electrode CNE2 which electrically connect the transistor TR and the light-emitting element ED. However, a configuration of the connection electrode CNE which electrically connects the transistor TR to the light-emitting element ED is not limited thereto. Either of the first connection electrode CNE1 or the second connection electrode CNE2 may be omitted, or an additional connection electrode may be further included.

The first connection electrode CNE1 may be disposed on the third insulating layer INS3. The first connection electrode CNE1 may be connected to the drain D1 via a first contact hole CH1 penetrating the first to third insulating layers INS1 to INS3. The fourth insulating layer INS4 may cover the first connection electrode CNE1 and be disposed on the third insulating layer INS3. The fifth insulating layer INS5 may be disposed on the fourth insulating layer INS4.

The second connection electrode CNE2 may be disposed on the fifth insulating layer INS5. The second connection electrode CNE2 may be connected to the first connection electrode CNE1 via a second contact hole CH2 penetrating the fourth and fifth insulating layers INS4 and INS5. The sixth insulating layer INS6 may cover the second connection electrode CNE2 and be disposed on the fifth insulating layer INS5.

The first to sixth insulating layers INS1 to INS6 may each include an inorganic layer or an organic layer. For example, the inorganic layer may include at least one of aluminium oxide, titanium oxide, silicon oxide, silicon oxynitride, zirconium oxide, and hafnium oxide. The organic layer may also include at least one of an acryl-based resin, a methacryl-based resin, a polyisoprene-based resin, a vinyl-based resin, an epoxy-based resin, a urethane-based resin, a cellulose-based resin, a siloxane-based resin, a polyamide-based resin, and a perylene-based resin.

The display element layer DP-EL may include a pixel-defining film PDL and the light-emitting element ED. The light-emitting element ED may include a first electrode AE, a hole control layer HCL, a light-emitting layer EML, an electron control layer TCL, and a second electrode CE.

The first electrode AE may be disposed on the sixth insulating layer INS6. The first electrode AE may be connected to the second connection electrode CNE2 via a third contact hole CH3 penetrating the sixth insulating layer INS6. The first electrode AE may be electrically connected to the drain D1 of the transistor TR via the first and second connection electrodes CNE1 and CNE2.

The first electrode AE may be formed of a metal material, a metal alloy, or a conductive compound. The first electrode AE may be an anode or a cathode. Additionally, the first electrode AE may be a pixel electrode. The first electrode AE may be a transmissive electrode, a transflective electrode, or a reflective electrode. The first electrode AE may include: at least one selected from Ag, Mg, Cu, Al, Pt, Pd, Au, Ni, Nd, Ir, Cr, Li, Ca, LiF, Mo, Ti, W, In, Sn, and Zn; or a compound of two or more materials thereamong; a mixture of two or more materials thereamong; or oxides thereof.

When the first electrode AE is the transmissive electrode, the first electrode AE may include a transparent metal oxide, for example, indium tin oxide (ITO), indium zinc oxide (IZO), zinc oxide (ZnO), indium tin zinc oxide (ITZO), etc. When the first electrode AE is the transflective electrode or the reflective electrode, the first electrode AE may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, or a compound or mixture thereof (for example, a mixture of Ag and Mg). Alternatively, the first electrode AE may have a multi-layered structure including a reflective film or a transflective film, which is formed of the above-described materials, and a transparent conductive film formed of indium tin oxide (ITO), indium zinc oxide (IZO), zinc oxide (ZnO), indium tin zinc oxide (ITZO), etc. For example, the first electrode AE may have a three-layered structure of ITO/Ag/ITO, but is not limited thereto. In addition, an embodiment is not limited thereto, and the first electrode AE may include the above-described metal materials, a combination of two or more metal materials thereamong, oxides of the above-described metal materials, or the like.

A pixel-defining film PDL may be disposed on the sixth insulating layer INS6. The pixel-defining film PDL may be formed of a polymer resin. For example, the pixel-defining film PDL may be formed of a polyacrylate-based resin or a polyimide-based resin. Additionally, the pixel-defining film PDL may be further formed of an inorganic material in addition to a polymer resin. The pixel-defining film PDL may be formed of a light-absorbing material or be formed of a black pigment or a black dye. The pixel-defining film PDL formed of a black pigment, or a black dye may constitute a black pixel-defining film. When forming the pixel-defining film PDL, carbon black, etc. may be used as a black pigment or a black dye, but an embodiment is not limited thereto.

Also, the pixel-defining film PDL may be formed of an inorganic material. For example, the pixel-defining film PDL may be formed of an inorganic material such as silicon nitride (SiNx), silicon oxide (SiOx), and silicon oxynitride (SiOxNy).

A light-emitting opening PX_OP which exposes a portion of the first electrode AE may be defined in the pixel-defining film PDL. A portion, of the first electrode AE, which is exposed by the light-emitting opening PX_OP may be defined as a light-emitting region LA.

The active region AA-DM of the display module DM may include the light-emitting region LA and a light-blocking region NLA. A region, in which the pixel-defining film PDL is disposed, may correspond to the light-blocking region NLA. The light-blocking region NLA may surround the light-emitting region LA in the active region AA-DM.

The hole control layer HCL may be disposed on the first electrode AE and the pixel-defining film PDL. The hole control layer HCL may be provided as a common layer overlapping the light-emitting region LA and the light-blocking region NLA. The hole control layer HCL may include at least one from a hole transport layer, a hole injection layer, and an electron blocking layer. The hole control layer HCL may include a typical hole injection material and/or a typical hole transport material.

The light-emitting layer EML may be disposed on the hole control layer HCL. The light-emitting layer EML may be disposed in a region corresponding to the light-emitting opening PX_OP. Unlike this, the light-emitting layer EML may also be provided as a common layer. The light-emitting layer EML may include an organic light-emitting material and/or an inorganic light-emitting material. The light-emitting layer EML may emit light having one color of red, green, or blue. For example, the light-emitting layer EML may emit blue light.

The electron control layer TCL may be disposed on the light-emitting layer EML. The electron control layer TCL may be provided as a common layer overlapping the light-emitting region LA and the light-blocking region NLA. The electron control layer TCL may include at least one of an electron transport layer, an electron injection layer, and a hole blocking layer. The electron control layer TCL may include a typical electron injection material and/or a typical electron transport material.

The second electrode CE may be disposed on the electron control layer TCL. The second electrode CE may be provided as a common layer overlapping the light-emitting region LA and the light-blocking region NLA.

The second electrode CE may be a common electrode. The second electrode CE may be a cathode or an anode. For example, when the first electrode AE is an anode, the second electrode CE may be a cathode, and when the first electrode AE is a cathode, the second electrode CE may be an anode.

The second electrode CE may be a transmissive electrode, a transflective electrode, or a reflective electrode. When the second electrode CE is a transmissive electrode, the second electrode CE may be formed of a transparent metal oxide, for example, indium tin oxide (ITO), indium zinc oxide (IZO), zinc oxide (ZnO), indium tin zinc oxide (ITZO), etc.

When the second electrode CE is the transflective electrode or the reflective electrode, the second electrode CE may include Ag, Mg, Cu, Al, Pt, Pd, Au, Ni, Nd, Ir, Cr, Li, Ca, LiF/Ca, LiF/Al, Mo, Ti, Yb, W, or a compound or mixture thereof (for example, AgMg, AgYb, or MgYb). Alternatively, the second electrode CE may have a multi-layered structure including a reflective film or a transflective film, which is formed of the above-described materials, and a transparent conductive film formed of indium tin oxide (ITO), indium zinc oxide (IZO), zinc oxide (ZnO), indium tin zinc oxide (ITZO), etc. For example, the second electrode CE may include the above-described metal materials, a combination of two or more metal materials selected from therefrom, oxides of the above-described metal materials, or the like.

An encapsulation layer TFE may be disposed on the second electrode CE and cover the light-emitting element ED. The encapsulation layer TFE may include a plurality of thin films. For example, the encapsulation layer TFE may include inorganic films, disposed on the second electrode CE, and an organic film disposed between the inorganic films. The inorganic film may protect the light-emitting element ED against moisture/oxygen, and the organic film may protect the light-emitting element ED against foreign substances such as dust particles.

An input-sensing part TP may include a first sensing-insulating layer IL1, a second sensing-insulating layer IL2, and a third sensing-insulating layer IL3. The input-sensing part TP may include at least one conductive layer disposed on the sensing-insulating layers. The input-sensing part TP may include a first conductive layer CDL1 and a second conductive layer CDL2.

The first sensing-insulating layer IL1 may be disposed on the encapsulation layer TFE. The first sensing-insulating layer IL1 may include at least one inorganic insulating layer. The first sensing-insulating layer IL1 may be in contact with the encapsulation layer TFE. Unlike this, the first sensing-insulating layer IL1 may also be omitted, and in this case, the first conductive layer CDL1 may be in contact with the encapsulation layer TFE.

The first conductive layer CDL1 may be disposed on the first sensing-insulating layer IL1. The first conductive layer CDL1 may include a plurality of first conductive patterns. The plurality of first conductive patterns may be disposed on the first sensing-insulating layer IL1. The second sensing-insulating layer IL2 may be disposed on the first sensing-insulating layer IL1 so as to cover at least a portion of the first conductive layer CDL1.

The second conductive layer CDL2 may be disposed on the second sensing-insulating layer IL2. The second conductive layer CDL2 may include a plurality of second conductive patterns. The plurality of second conductive patterns may be disposed on the second sensing-insulating layer IL2. The plurality of second conductive patterns may be each connected to the plurality of first conductive patterns via a contact hole formed in the second sensing-insulating layer IL2.

The plurality of first conductive patterns of the first conductive layer CDL1 and the plurality of second conductive patterns of the second conductive layer CDL2 may each be disposed to correspond to the light-blocking region NLA. The plurality of first conductive patterns of the first conductive layer CDL1 and the plurality of second conductive patterns of the second conductive layer CDL2 may each correspond to a mesh pattern.

The third sensing-insulating layer IL3 may be disposed on the second sensing-insulating layer IL2 and cover the second conductive layer CDL2. The second sensing-insulating layer IL2 and the third sensing-insulating layer IL3 may each include an inorganic insulating layer or an organic insulating layer.

The first conductive layer CDL1 and the second conductive layer CDL2 may each have a single-layered structure or a multi-layered structure in which layers are stacked along the third direction DR3. The conductive layers CDL1 and CDL2 having a single-layered structure may include a metal layer or a transparent conductive layer. The metal layer may include molybdenum, silver, titanium, copper, aluminium, or an alloy thereof. The transparent conductive layer may include a transparent conductive oxide such as indium tin oxide (ITO), indium zinc oxide (IZO), zinc oxide (ZnO), and indium zinc tin oxide (IZTO). Additionally, the transparent conductive layer may include a conductive polymer such as PEDOT, a metal nanowire, graphene, etc.

The conductive layers CDL1 and CDL2 having a multi-layered structure may include metal layers. For example, the metal layers may have a three-layered structure of titanium (Ti)/aluminium (Al)/titanium (Ti). The conductive layers CDL1 and CDL2 having a multi-layered structure may include at least one metal layer and at least one transparent conductive layer.

FIGS. 7A to 7D are schematic views illustrating a method for manufacturing an adhesive member AP from a resin composition RC according to an embodiment. For example, the method for manufacturing the adhesive member AP may include steps of: providing the resin composition RC on a substrate CF; forming a preliminary adhesive member P-AP by providing first light UV-1 to the resin composition RC; and forming the adhesive member AP by providing second light UV-2 to the preliminary adhesive member P-AP. Hereinafter, with regard to the descriptions of FIGS. 7A to 7D, the contents duplicated with those described with the references to FIGS. 1 to 6 will not be explained again, and the following description will be mainly focused on the differences.

Referring to FIG. 7A, the resin composition RC according to an embodiment may be provided on the substrate CF. The resin composition RC may be provided on the substrate CF via a nozzle NZ. For example, the substrate CF provided with the resin composition RC may include polyethylene terephthalate (PET). The substrate CF is a temporary substrate which is used to form the adhesive member AP (see FIGS. 4 and 5) from the resin composition RC, and may be used without limitation as long as a substrate may be easily detached after the resin composition RC is cured. One surface of the substrate CF on which the resin composition RC is provided may have been subjected to a releasing process.

The resin composition RC according to an embodiment may be provided through an inkjet printing method or a dispensing method. In an embodiment, the liquid resin composition RC may be provided in a uniform amount and/or at a uniform rate. FIG. 7A illustrates that the resin composition RC is provided via the nozzle NZ, but an apparatus for providing the resin composition RC is not limited thereto.

The resin composition RC according to an embodiment includes a urethane acrylate compound including a structure according to Chemical Formula 1, a monomer having one polymerizable unsaturated group per molecule, and a photopolymerization initiator.

All the structures of Chemical Formula 1 described in this specification may be according to Chemical Formula 1.

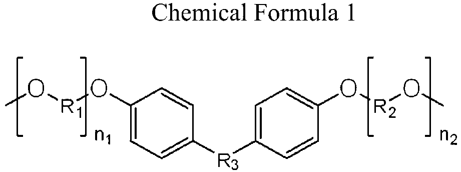

In Chemical Formula 1, R₁ and R₂ may each be independently a substituted or unsubstituted alkylene group having 1 to 4 carbon atoms. For example, the alkylene group may include a methylene group, an ethylene group, a propylene group, a butylene group, etc. The alkylene group may be linear, branched, or cyclic. R₁ to R₂ may be the same or different from each other.

In Chemical Formula 1, R₃ is a substituted or unsubstituted alkylene group having 1 to 3 carbon atoms. For example, the alkylene group may include a methylene group, an ethylene group, or a propylene group. The alkylene group may be linear, branched, or cyclic. R₃ may be the same as or different from R₁ and R₂.

In an embodiment, R₁ and R₂ may be a branched propylene group, such as -CH(CH₃)CH₂-. In an embodiment, R₃ may be a branched propylene group, or an ethylene group.

In Chemical Formula 1, subscript n₁ and subscript n₂ are each independently an integer of 1 to 6. Subscript n₁ and subscript n₂ may be the same or different from each other.

The urethane acrylate compound including the structure according to Chemical Formula 1 may be a single compound, or may be used in a combination of two or more different urethane acrylate compounds.

The urethane acrylate compound including the structure according to Chemical Formula 1 may have a weight-average molecular weight Mw of about 3000 g/mol to about 15000 g/mol. The weight-average molecular weight may be determined by gel permeation chromatography and calculated as a standard polystyrene-conversion value.

The urethane acrylate compound including the structure according to Chemical Formula 1 may have a number-average molecular weight Mn of about 2000 g/mol to about 7000 g/mol. The number-average molecular weight may be determined by an end group titration method using nuclear magnetic resonance spectroscopy, etc., but a method is not limited thereto as long as the method may be appropriately selected by those skilled in the art.

For example, the weight-average molecular weight Mw and the number-average molecular weight Mn according to an embodiment were determined by using a Gel Permeation Chromatography (GPC) analysis device, "HLC-8420GPC", manufactured by TOSOH Corporation. The values of the weight-average molecular weight Mw and the number-average molecular weight Mn may be calculated from standard polystyrene (PS) conversion selected from the SEC curve which is detected by the RI detector, using TSKgel SUPER HZM-N as the measurement column.

The resin composition RC according to an embodiment includes the urethane acrylate compound including the structure according to Chemical Formula 1, thereby having a low viscosity before curing and exhibiting an increased adhesive strength at room temperature and also at increased temperatures after curing.

The resin composition includes the urethane acrylate compound, which includes the structure according to Chemical Formula 1, in an amount of about 5% by weight to about 18% by weight with respect to the total weight of the resin composition. When the urethane acrylate compound in the resin composition is contained in an amount less 5% by weight, a 180° peeling strength measured at about 25 °C and about 60 °C on a glass substrate after curing may be significantly less than a resin composition having from 5% by weight to 18% by weight. When the urethane acrylate compound in the resin composition is contained in an amount exceeding 18% by weight, a 180° peeling strength measured at about 25 °C on a glass substrate after curing may be significantly less than a resin composition having from 5% by weight to 18% by weight, and a viscosity before curing may be high.

The structure according to Chemical Formula 1 in the urethane acrylate compound is contained in an amount of about 20% by weight to about 60% by weight with respect to the total weight of the urethane acrylate compound. When the structure according to Chemical Formula 1 is contained in an amount less than 20% by weight, the resin may have a 180° peeling strength measured at about 25 °C and about 60 °C on a glass substrate that is significantly less than a resin having from 20% by weight to 60% by weight of Chemical Formula 1 in the respect to the total weight of the urethane acrylate compound, and a storage modulus measured at about 25 °C may be greater than a resin having from 20% by weight to 60% by weight of Chemical Formula 1 in the respect to the total weight of the urethane acrylate compound. When the structure according to Chemical Formula 1 is contained in an amount exceeding 60% by weight, a 180° peeling strength measured at about 25°C on a glass substrate may be significantly less than a resin having from 20% by weight to 60% by weight of Chemical Formula 1 in the respect to the total weight of the urethane acrylate compound.

The urethane acrylate compound including the structure according to Chemical Formula 1 may be synthesized from a reactant including: a first polyfunctional alcohol including the structure according to Chemical Formula 1; a second alcohol different from the first polyfunctional alcohol; a polyfunctional isocyanate-based compound; and a compound including at least one (meth)acryloyl group and at least one hydroxyl group per molecule. However, a composition of the reactant is not limited thereto, and additional components may be appropriately included as long as the components do not significantly affect the resulting product. When the urethane acrylate compound including the structure according to Chemical Formula 1 is synthesized, a catalyst, etc. may be added in addition to a reactant.

In this specification, the (meth)acryloyl group refers to an acryloyl group or methacryloyl group, and the (meth)acrylic refers to acrylic or methacrylic.

For example, the first polyfunctional alcohol according to an embodiment may include 2,2-bis(4-polyoxypropyleneoxyphenyl)propane. For example, the first polyfunctional alcohol according to an embodiment may include 2,2-bis(4-polyoxypropyleneoxyphenyl)propane and 2,2-bis(4-polyoxypropyleneoxyphenyl)ethane. However, this is presented as an example, and the polyfunctional alcohol including the structure according to Chemical Formula 1 is not limited thereto. The polyfunctional alcohol including the structure according to Chemical Formula 1 may be a single compound, or may be used in a combination of two or more compounds.

For example, the first polyfunctional alcohol may be contained in an amount of about 20% by weight to about 60% by weight with respect to the total weight of the reactant. However, this is presented as an example, the composition may be appropriately modified by those skilled in the art within the same range.

The second alcohol may be different from the first polyfunctional alcohol. The second alcohol may include a polyfunctional alcohol different from the first polyfunctional alcohol. The second alcohol may further include a monofunctional alcohol in addition to a polyfunctional alcohol. The second alcohol may be a single compound, or may be used in a combination of two or more compounds.

The second alcohol may include 2,2-bis(hydroxymethyl)butyric acid. The second alcohol may include 2,2-bis(hydroxymethyl)butyric acid and ethanol.

When the urethane acrylate included in the resin composition according to an embodiment is synthesized, an adhesive strength at high temperature may be significantly increased after the resin composition is photocured in the case in which the second alcohol, served as a reactant, includes 2,2-bis(hydroxymethyl)butyric acid. This may be because a main chain of 2,2-bis(hydroxymethyl)butyric acid includes a carboxylic acid group.

When the second alcohol does not include 2,2-bis(hydroxymethyl)butyric acid, the resin composition including the urethane acrylate synthesized from such a reactant may have a 180° peeling strength of less than about 200 gf/25 mm, as measured at 60 °C with respect to a glass substrate after photocuring.

For example, the second alcohol may be contained in an amount of about 1% by weight to about 20% by weight with respect to the total weight of the reactant. However, this is presented as an example, the composition may be appropriately modified by those skilled in the art within the same range.

For example, the polyfunctional isocyanate-based compound may include at least one of 1,3-bis(isocyanatomethyl)cyclohexane, and isophorone diisocyanate. However, this is presented as an example, and the polyfunctional isocyanate-based compound is not limited thereto. The polyfunctional isocyanate-based compound may be a single compound, or may be used in a combination of two or more compounds. For example, the polyfunctional isocyanate may be contained in an amount of about 20% by weight to about 50% by weight with respect to the total weight of the reactant.

The polyfunctional isocyanate according to an embodiment may include 1,3-bis(isocyanatomethyl)cyclohexane.

For example, the compound including at least one (meth)acryloyl group and at least one hydroxyl group per molecule may include 2-hydroxyethyl acrylate or PLACCEL FA1DDM (manufactured by Daicel Corp.) However, this is presented as an example, and a compound is not limited thereto as long as the compound includes at least one (meth)acryloyl group and at least one hydroxyl group per molecule.

When the urethane acrylate compound including the structure according to Chemical Formula 1 is synthesized, a catalyst, etc. may further be added in addition to a reactant. For example, dibutyltin dilaurate may be used as a catalyst. However, this is presented as an example, and a catalyst is not limited thereto as long as the catalyst may be appropriately selected by those skilled in the art.

The monomer having one polymerizable unsaturated group per molecule may be contained in an amount of about 50% by weight to about 93% by weight with respect to the total weight of the resin composition. For example, the monomer having one polymerizable unsaturated group per molecule may be contained in an amount of about 70% by weight to about 93% by weight.

In this case, a polymerizable unsaturated group may refer to a functional group having an unsaturated bond capable of participating in a polymerization reaction, and the unsaturated group may include a double bond or a triple bond. For example, the polymerizable unsaturated group may include an acrylate group, an acryloyl group, a vinyl group, an allyl group, a methacrylic group, etc.

The monomer having one polymerizable unsaturated group per molecule may include at least one of 4-hydroxybutyl acrylate, tetrahydrofurfuryl acrylate, isobornyl acrylate, isodecyl acrylate, dicyclopentenyl acrylate, lauryl acrylate (C12), stearyl acrylate (C18), isostearyl acrylate, 2-ethylhexyl acrylate, isoamyl acrylate, 2-(2-ethoxyethoxy)ethyl acrylate, phenoxyethyl acrylate, phenoxydiethyleneglycol acrylate, 2-{2-[(2-ethylhexyl)oxy]ethoxy}ethyl acrylate, 1,4-cyclohexanedimethanol monoacrylate, N,N-diethylacrylamide, N-(2-hydroxyethyl)acrylamide, and 4-acryloylmorpholine. However, this is presented as an example, and the monomer including a polymerizable unsaturated group, which is included in the resin composition RC, is not limited thereto. The monomer including a polymerizable unsaturated group, which is included in the resin composition RC, may be a single compound, or may be used in a combination of two or more compounds.

In an embodiment, a monomer having one polymerizable unsaturated group per molecule may include an acrylate group as a polymerizable unsaturated group.

The resin composition RC according to an embodiment includes a photopolymerization initiator. The photopolymerization initiator may refer to a substance that absorbs light, such as ultraviolet light, to cause the polymerization reaction of a monomer or an oligomer.

For example, the photopolymerization initiator may include at least one of 2,2-dimethoxy-1,2-diphenylethan-1-one, 1-hydroxy cyclohexyl-phenylketone, 2-hydroxy-2-methyl-1-phenyl-1-propanone, 2-hydroxy-1-[4-(2-hydroxyethoxy)phenyl]-2-methyl-1-propanone, and 2-hydroxy-1-{4-[4-(2-hydroxy-2-methyl-propionyl)-benzyl]-phenyl}-2-methylpropan-1-one.

Additionally, the photopolymerization initiator may include at least one of 2-methy1-1[4-(methylthio)pheny1]-2-morpholinopropan-1-one, 2-benzyl-2-dimethylamino-1-(4-morpholinophenyl)-butanone-1, 2-dimethylamino-2-(4-methylbenzyl)-1-(4-morpholin-4-yl-phenyl)-butan-1-one, 2,4,6-trimethylbenzoyldiphenylphosphine oxide, ethyl(2,4,6-trimethylbenzoyl)phenyl phosphinate, phenylbis(2,4,6-trimethylbenzoyl)phosphine oxide, [1-(4-phenylsulfanylbenzoyl)heptylideneamino]benzoate, [1-[9-ethyl-6-(2-methylbenzoyl)carbazol-3-yl]ethylideneamino] acetate, and bis(2,4-cyclopentadienyl)bis[2,6-difluoro-3-(1-pyrryl)phenyl] titanium(IV).

In an embodiment, the resin composition may include bis(2,4,6-trimethylbenzoyl)phenylphosphine oxide and/or α-hydroxyalkylphenone as a photopolymerization initiator. The photopolymerization initiator may be a single compound, or may be used in a combination of two or more compounds. However, a photopolymerization initiator is not limited to the above-described types, and may be used without limitation as long as the photopolymerization initiator falls within a range appropriately selectable by those skilled in the art. For example, the photopolymerization initiator may be contained in an amount of about 1% by weight to about 5% by weight with respect to the total weight of the resin composition.

The resin composition RC according to an embodiment may have a 180° peeling strength of about 2000 gf/25 mm to about 5000 gf/25 mm, which is measured at about 25 °C with respect to a glass substrate after photocuring in air under the condition that an ultraviolet accumulated light quantity is less than about 2000 mJ/cm². After curing, when at room temperature, the resin composition RC has a 180° peeling strength of less than about 2000 gf/25 mm with respect to a glass substrate, the resin composition RC may not have a sufficient adhesive strength to the adjacent components of the display device (for example, the display module and/or the window).

The resin composition RC according to an embodiment may have a 180° peeling strength of about 250 gf/25 mm to about 1000 gf/25 mm, which is measured at about 60 °C with respect to a glass substrate after photocuring in air under the condition that an ultraviolet accumulated light quantity is less than about 2000 mJ/cm². After curing, when at high temperature, the resin composition RC has a 180° peeling strength of less than about 250 gf/25 mm with respect to a glass substrate, the resin composition RC may have a low adhesion reliability.

The resin composition RC according to an embodiment may have a viscosity of about 5 mPa·s to about 20 mPa·s, which is measured at about 25°C before curing. When the resin composition RC has a viscosity of less than about 5 mPa·s, which is measured at about 25 °C before curing, an adhesive strength and a mechanical strength may be decreased after curing. When the resin composition RC has a viscosity of greater than about 20 mPa·s, which is measured at about 25 °C before curing, it is difficult to coat a substrate with the resin composition, and thus a processability may be deteriorated. On the contrary, when the resin composition has a viscosity satisfying the above-described range, an excellent coatability and adhesive strength after curing may be achieved.

The resin composition RC according to an embodiment may have a glass transition temperature, Tg, of about -20 °C to about 20 °C, about -20 °C to about 10 °C, or about -20 °C to about 5 °C after curing. When the glass transition temperature, Tg, is less than about -20 °C after curing, resistance is reduced in a high-temperature and high-humidity environment, and thus the adhesion strength may be deteriorated. Additionally, when the glass transition temperature, Tg, is greater than about 20 °C after curing, the polymer derived from the resin composition has high cohesion, which may result in susceptibility to external impact. On the contrary, when the glass transition temperature, Tg, satisfies a range of about -20 °C to about 20 °C, an adhesive strength as well as a durability may be appropriately achieved.

The resin composition RC according to an embodiment may have a storage modulus of about 0.02 megapascal (Mpa) to about 0.2 Mpa, which is measured at about 25 °C after curing. When the storage modulus is less than about 0.02 Mpa after curing, the mechanical strength is low, which may result in susceptibility to impact. On the contrary, when the storage modulus is greater than about 0.2 Mpa after curing, a flexibility and an adhesive strength may be deteriorated.

Accordingly, the resin composition RC according to an embodiment may have a low viscosity before curing, and exhibit an excellent adhesion reliability after curing. Also, the adhesive member formed by curing the resin composition RC according to an embodiment, and the electronic apparatus including the adhesive member, may also have an excellent adhesion reliability.

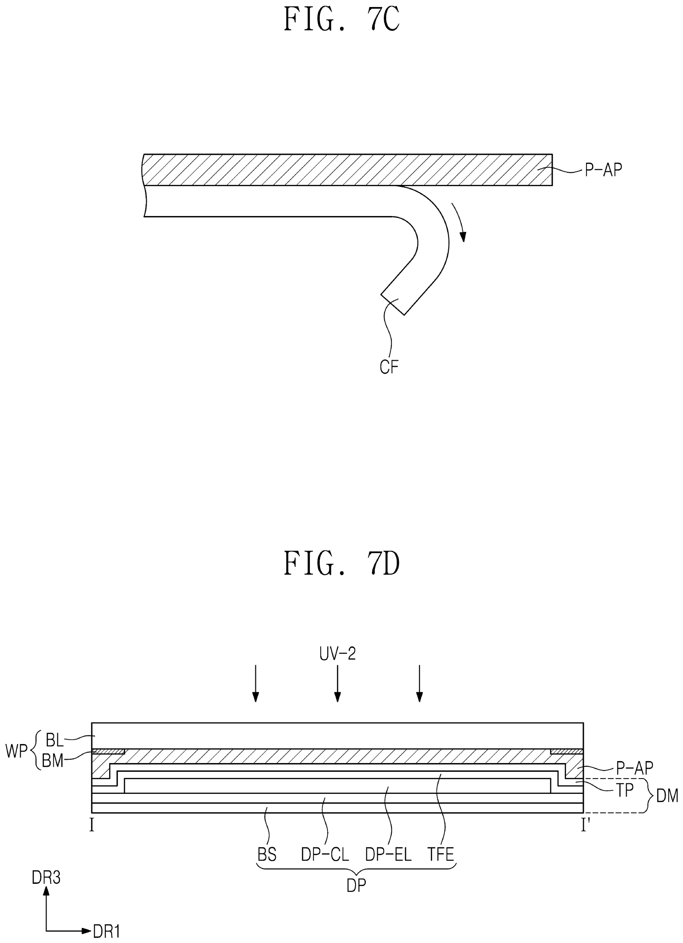

Referring to FIG. 7B, the first light UV-1 may be provided to the resin composition RC applied on a substrate CF with a uniform thickness. The liquid resin composition RC may be cured by the first light UV-1 to form a preliminary adhesive member P-AP (see FIG. 7C). The first light UV-1 may be ultraviolet light. FIG. 7B illustrates that the preliminary adhesive member P-AP is formed by directly irradiating the resin composition RC applied on the substrate CF with the first light UV-1, but the embodiment is not limited thereto. A carrier film (not illustrated) may be disposed on the resin composition RC applied with a uniform thickness, and the carrier film (not illustrated) may transmit ultraviolet light.

Referring to FIGS. 7C and 7D, the preliminary adhesive member P-AP which is formed by irradiating the resin composition RC with the first light UV-1 (see FIG. 7B) may be detached from the substrate CF and provided on one surface of a window WP or one surface of a display module DM. One surface of the preliminary adhesive member P-AP is stacked on the one surface of the window WP or the one surface of the display module DM, and another surface of the display module DM or another of the window WP, which is not attached, may be attached to the other surface of the preliminary adhesive member P-AP. Thereafter, the preliminary adhesive member P-AP is irradiated with the second light UV-2 to form the adhesive member AP (see FIGS. 4 and 5). The second light UV-2 may be ultraviolet light. The second light UV-2 is provided from above the window WP, and the window WP may transmit the second light UV-2. The second light UV-2 may pass through the window WP to be provided to the preliminary adhesive member P-AP. Additionally, the second light UV-2 may pass through a printed layer BM to be provided to the preliminary adhesive member P-AP.

One region of the preliminary adhesive member P-AP, which overlaps the printed layer BM, may be irradiated with a smaller amount of the second light UV-2 than the other region of the preliminary adhesive member P-AP, which does not overlap the printed layer BM.

FIGS. 7A to 7D illustrate that the adhesive member AP (FIGS. 4 and 5) is formed by curing the resin composition RC twice (for example, cured by providing light twice), but an embodiment is not limited thereto. For example, the resin composition RC may be cured once to form the adhesive member AP or may also be cured three or more times to form the adhesive member AP.

FIGS. 8A to 8C are schematic views illustrating a method for manufacturing an adhesive member AP from a resin composition RC according to an embodiment. Hereinafter, with regard to the descriptions of FIGS. 8A to 8C, the contents duplicated with those described with the references to FIGS. 1 to 7D will not be explained again, and the following description will be mainly focused on the differences.

For example, the method for manufacturing the adhesive member AP, which is illustrated in FIGS. 8A to 8C, may include steps of: providing the resin composition RC on a display module DM; forming a preliminary adhesive member PAP by providing first light UV-1 to the resin composition RC; and forming the adhesive member AP by providing second light UV-2 to the preliminary adhesive member P-AP. The manufacturing method illustrated in FIGS. 8A to 8C differs from the manufacturing method illustrated in FIGS. 7A to 7D in that the resin composition RC is provided on the display module DM.

The resin composition RC may be directly provided on one surface of the display module DM or one surface of a window WP. FIG. 8A illustrates that the resin composition RC is directly provided on one surface of the display module DM.

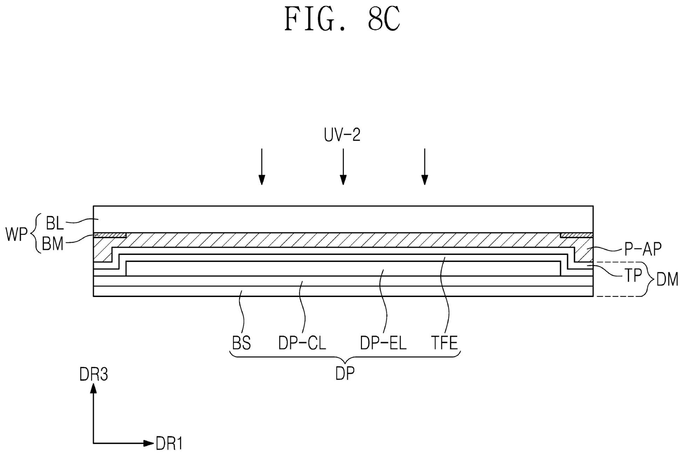

Referring to FIG. 8B, the first light UV-1 may be provided to the uniformly applied resin composition RC. The first light UV-1 is provided to the resin composition RC, and then the preliminary adhesive member P-AP may be formed. The window WP may be provided on the preliminary adhesive member P-AP. Referring to FIG. 8C, the second light UV-2 may pass through the window WP to be provided to the preliminary adhesive member P-AP. Additionally, the second light UV-2 may pass through the printed layer BM to be provided to the preliminary adhesive member P-AP. The preliminary adhesive member P-AP may be cured by the second light UV-2 to form the adhesive member AP (see FIG. 5).

The adhesive member AP (see FIG. 5) formed of the resin composition RC according to an embodiment may exhibit a high adhesive strength. Additionally, the adhesive member AP (see FIG. 5) formed of the resin composition RC according to an embodiment may exhibit a high adhesive strength even below the printed layer BM.

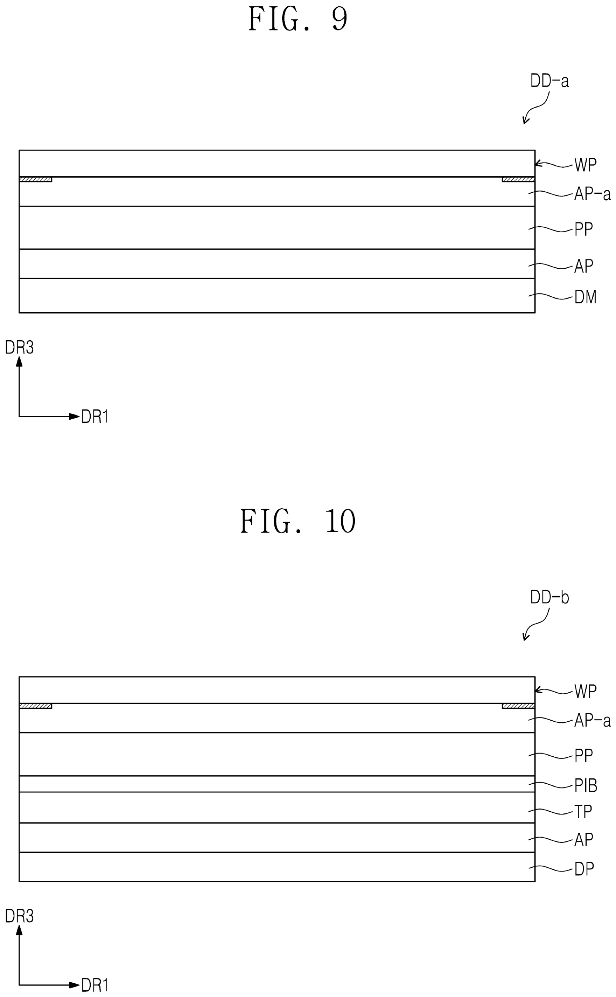

FIGS. 9 and 10 are respectively cross-sectional views illustrating a display devices according to an embodiment. Hereinafter, with regard to the descriptions of the display device according to an embodiment, which is described with reference to FIGS. 9 to 10, the contents duplicated with those described with the references to FIGS. 1 to 8C will not be explained again, and the following description will be mainly focused on the differences.

A display device DD-a illustrated in FIG. 9 may further include a light control layer PP and an optical adhesive layer AP-a, compared to the display device DD illustrated with reference to FIGS. 4 and 5. The display device DD-a according to an embodiment may further include the light control layer PP disposed between the adhesive member AP and a window WP, and the optical adhesive layer AP-a disposed between the light control layer PP and the window WP. The light control layer PP may include a polarization plate or a color filter layer.

The optical adhesive layer AP-a may be formed of a resin composition RC according to an embodiment. The optical adhesive layer AP-a including a polymer derived from the resin composition RC may exhibit an excellent adhesive strength. The display device DD including the optical adhesive layer AP-a may exhibit an excellent reliability and display quality.

A display device DD-b according to an embodiment illustrated in FIG. 10 may further include the light control layer PP, the optical adhesive layer AP-a, and an interlayer adhesive layer PIB, compared to the display device DD illustrated with reference to FIGS. 4 and 5.

In the display device DD-b according to an embodiment, an adhesive member AP may be provided between a display panel DP and an input-sensing part TP. That is, the input-sensing part TP is not directly disposed on the display panel DP, but the input-sensing part TP may be coupled to the display panel DP via the adhesive member AP. For example, the adhesive member AP may be disposed between the encapsulation layer TFE (see FIG. 5) of the display panel DP and the input-sensing part TP.

The interlayer adhesive layer PIB may be provided below the light control layer PP. The interlayer adhesive layer PIB is disposed between the input-sensing part TP and the light control layer PP, and may be formed of an adhesive material having excellent moisture permeability prevention properties. For example, the interlayer adhesive layer PIB may be formed of polyisobutylene. The interlayer adhesive layer PIB may be disposed on the input-sensing part TP to prevent corrosion of sensing electrodes of the input sensing unit TP. The display device DD-b according to an embodiment includes the optical adhesive layer AP-a and the adhesive member AP which are formed of the resin composition RC according to an embodiment, and the display device DD-b including the optical adhesive layer AP-a and the adhesive member AP may exhibit an excellent reliability and display quality.

Hereinafter, a resin composition according to an embodiment of the inventive concept, and an adhesive member formed of the resin composition will be described in detail with reference to Examples and Comparative Examples. Also, the following embodiment is only an illustration to assist the understanding of the inventive concept, and the scope of the inventive concept is not limited thereto.

### EXAMPLE

Table 1 shows composition components and contents of the resin composition according to Examples and Comparative Examples. The resin compositions were prepared as a liquid resin composition by stirring the components in Table 1 below at room temperature. The content of each component in Table 1 was measured in a light-shielding container.

Also, Table 2 shows compounds and contents thereof used for the synthesis of urethane acrylates of A-1 to A-9, which are provided in the resin composition according to Examples and Comparative Examples. The synthesis method for A-1 to A-9 will be described below in more detail.

The resin compositions according to Examples 1 to 7 include a urethane acrylate compound including a structure according to Chemical Formula 1, a monomer having one polymerizable unsaturated group per molecule, and a photopolymerization initiator. A content of urethane acrylate in the resin composition according to Examples 1 to 7 falls within the range of about 5% by weight to about 18% by weight with respect to the total weight of the resin composition. The structure according to Chemical Formula 1 in the urethane acrylate of Examples 1 to 7 falls within the range of about 20% by weight to about 60% by weight with respect to the total weight of the urethane acrylate compound. The content of the monomer in the resin composition according to Examples 1 to 7 falls within the range of about 50% by weight to about 95% by weight with respect to the total weight of the resin composition.

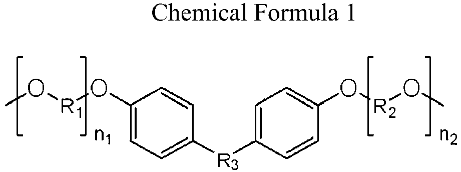

In Chemical Formula 1, R₁ and R₂ are each independently a substituted or unsubstituted alkylene group having 1 to 4 carbon atoms, R₃ is a substituted or unsubstituted alkylene group having 1 to 3 carbon atoms, and n₁ and n₂ are each independently an integer of 1 to 6.

In Examples 1 to 7, A-1 to A-7 were used as the urethane acrylate compounds containing the structure according to Chemical Formula 1 in the resin compositions. The method for synthesizing A-1 to A-7 is provided proceeding Table 1.

In the Examples, 4-HBA, THF-A, IBXA, IDAA, and FA-511 were used as monomers having one polymerizable unsaturated group per molecule. In the Examples, either Omnirad 819 or Omnirad 184 was used as a photopolymerization initiator.

In Comparative Examples 1 to 3, a urethane acrylate compound not including the structure according to Chemical Formula 1 was used.

In Comparative Examples 4 and 5, the urethane acrylate compound including the structure according to Chemical Formula 1 was used, but the structure according to Chemical Formula 1 in the urethane acrylate compound was contained in an amount of less than about 20% by weight or greater than about 60% by weight with respect to the total weight of the urethane acrylate compound.

In Comparative Examples 6 and 7, the urethane acrylate compound including the structure according to Chemical Formula 1 was used, but the urethane acrylate compound was contained in an amount of less than about 5% by weight or about 18% by weight or greater than with respect to the total weight of the resin composition.

**Table 1**

| | | Example | | | | | | | Comparative Example | | | | | | |
|---|---|---|---|---|---|---|---|---|---|---|---|---|---|---|---|
| | | 1 | 2 | 3 | 4 | 5 | 6 | 7 | 1 | 2 | 3 | 4 | 5 | 6 | 7 |
| Urethane Acrylate (including the structure according to Chemical Formula 1) (g) | A-1 | 1.1 | | | | | | | | | | | | | |
| | A-2 | | 1.3 | | | | | | | | | | | | |
| | A-3 | | | 1.2 | | | 0.6 | 2.2 | | | | | | 0.5 | 2.5 |
| | A-4 | | | | 1.2 | | | | | | | | | | |
| | A-5 | | | | | 1.2 | | | | | | | | | |
| | A-6 | | | | | | | | | | | 1.2 | | | |
| | A-7 | | | | | | | | | | | | 1.2 | | |
| Urethane Acrylate (not including the structure according to Chemical Formula 1) (g) | A-8 | | | | | | | | | 1.1 | | | | | |
| | UV330 0B | | | | | | | | 1.1 | | | | | | |
| | A-9 | | | | | | | | | | 1.1 | | | | |
| Monomer having one polymeriza ble unsaturated group per molecule (g) | 4-HBA | 1.0 | 1.6 | 1.5 | 1.5 | 1.5 | 1.5 | 1.5 | 1.0 | 1.6 | 1.0 | 1.5 | 1.5 | 1.5 | 1.5 |
| | THF-A | 2.0 | 3.2 | 5 | 5 | 5 | 5 | 5 | 2.0 | 3.2 | 2.0 | 5 | 5 | 5 | 5 |
| | IBXA | 1.0 | | 1.5 | 1.5 | 1.5 | 1.5 | 1.5 | 1.0 | | 1.0 | 1.5 | 1.5 | 1.5 | 1.5 |
| | IDAA | 5.0 | | 2 | 2 | 2 | 2 | 2 | 5.0 | | 5.0 | 2 | 2 | 2 | 2 |
| | FA511 | | 1.8 | | | | | | | 1.8 | | | | | |
| Photopolym erization initiator (g) | Omnir ad819 | 0.1 9 | 0.0 4 | 0.0 7 | 0.0 7 | 0.0 7 | 0.0 7 | 0.0 7 | 0.1 9 | 0.0 4 | 0.1 9 | 0.0 7 | 0.0 7 | 0.0 7 | 0.0 7 |
| | Onmir ad184 | | 0.1 6 | 0.4 | 0.4 | 0.4 | 0.4 | 0.4 | | 0.1 6 | | 0.4 | 0.4 | 0.4 | 0.4 |
| Content of Urethane acrylate (% by weight) | | 10. 69 | 16. 05 | 10. 28 | 10. 28 | 10. 28 | 5.4 2 | 17. 36 | 10. 69 | 13. 92 | 10. 69 | 10. 28 | 10. 28 | 4.5 6 | 19. 28 |
| Content of Monomer (% bv weight) | | 87. 46 | 81. 48 | 85. 69 | 85. 69 | 85. 69 | 90. 33 | 78. 93 | 87. 46 | 83. 54 | 87. 46 | 85. 69 | 85. 69 | 91. 16 | 77. 10 |

The compounds used in Table 1 are as follows, and a content of each components is expressed in gram (g). In addition, the term "weight percent" in Table 1 is calculated with respect to the total weight of the resin composition, and the term "a content of a monomer" refers to "an amount of a monomer having one polymerizable unsaturated group per molecule."
4-HBA: 4-hydroxybutyl acrylate (Osaka Organic Chemical Industry Ltd.)
THF-A: tetrahydrofurfuryl acrylate (Kyoeisha Chemical Co., Ltd.)
IBXA: isobornyl acrylate (Osaka Organic Chemical Industry Ltd.)
IDAA: isodecyl acrylate (Osaka Organic Chemical Industry Ltd.)
FA-511: dicyclopentenyl acrylate (Resonac Corporation)
UV3300B: urethane acrylate with a molecular weight of 13000 (Mitsubishi Chemical Corporation)
Omnirad 819: bis(2,4,6-trimethylbenzoyl)phenyl phosphine oxide (IGM Resin)
Omnirad 184: α-hydroxy alkyl phenone (IGM Resin)

Additionally, urethane acrylate compounds of A-1 to A-9, used in Table 1 above, were manufactured using the compounds in Table 2 below.

Among these, A-1 to A-7 refer to a urethane acrylate compound including the structure according to Chemical Formula 1 in the urethane acrylate compound, and A-8 and A-9 refer to a urethane acrylate compound not including the structure according to Chemical Formula 1.

The urethane acrylate compound used for a resin composition in Examples 1 to 7 corresponds to a compound synthesized from a reactant including: a first polyfunctional alcohol including the structure according to Chemical Formula 1; a second alcohol different from the first polyfunctional alcohol; a polyfunctional isocyanate-based compound; and a compound including at least one (meth)acryloyl group and at least one hydroxyl group per molecule. A catalyst was used together during the synthesis of the urethane acrylate compound.

In this case, 2,2-bis(4-polyoxypropyleneoxyphenyl)ethane or 2,2-bis(4-polyoxypropyleneoxyphenyl)propane was used as the first polyfunctional alcohol including the structure according to Chemical Formula 1. Also, 2,2-bis(hydroxymethyl)butyric acid was used as the second alcohol. 2-hydroxyethyl acrylate or PLACCEL FA1DDM was used as the compound including at least one (meth)acryloyl group and at least one hydroxyl group per molecule. Dibutyltin dilaurate was used as the catalyst.

In the urethane acrylate compound used for the resin composition in Examples 1 to 7, the structure according to Chemical Formula 1 is contained in an amount of about 20% by weight to about 60% by weight with respect to the total weight of the urethane acrylate compound.

### (Synthesis Method for A-1)

About 18.9 parts by weight of BA-2, about 20.7 parts by weight of BA-P2M, about 3.8 parts by weight of 2-hydroxyethyl acrylate, about 0.011 parts by weight of dibutyltin dilaurate were charged into a flask provided with a stirring bar, a temperature sensor, and a water-cooled condenser, and were mixed with the stirring bar to prepare a mixture, and then the mixture was heated to about 60 °C.

Afterwards, about 32.0 parts by weight of 1,3-bis(isocyanatomethyl)cyclohexane was added to the mixture while being heated to about 85 °C with care to avoid excessive heat and maintained for about 2 hours.

Upon confirming that the content of isocyanate was about 3.0% by weight or less with respect to the total weight of the mixture, the temperature was lowered to about 70 °C. Afterwards, about 3.1 parts by weight of ethanol was added, and the temperature was raised to about 80 °C. Subsequently, the mixture was reacted until the content of isocyanate reached about 0.1% by weight with respect to the total weight of the mixture containing ethanol. Thereafter, the mixture was cooled, and the urethane acrylate A-1 was obtained. Here, the term "a content of isocyanate" refers to an amount of isocyanate groups present in the sample, which is expressed in weight percent (% by weight) and calculated by reacting the mixture with a dibutylamine solution and measuring the titration volume with a standard hydrochloric acid solution.

The obtained urethane acrylate had a weight-average molecular weight Mw of about 6100 g/mol. Hereinafter, the same procedure was also applied to A-2 to A-9, which were prepared by varying components and contents in Table 2.

The synthesized urethane acrylate compounds of A-1 to A-5 have a weight-average molecular weight Mw of about 3,000 g/mol to about 15000 g/mol and a number-average molecular weight Mn of about 2000 g/mol to about 7000 g/mol.

In the urethane acrylate compounds of A-1 to A-5, which are synthesized through the above-described method, the structure represented by Chemical Formula 1 is contained in an amount of about 20% by weight to about 60% by weight with respect to the total weight of the urethane acrylate compound.

On the contrary, in the urethane acrylate compound of A-6, the structure according to Chemical Formula 1 is contained in an amount of less than about 20% by weight with respect to the total weight of the urethane acrylate compound. Also, in the urethane acrylate compound of A-7, the structure according to Chemical Formula 1 is contained in an amount of about 60% by weight or more with respect to the total weight of the urethane acrylate compound.

The urethane acrylate compound of A-8 differs from the compounds of A-1 to A-7 in that the first polyfunctional alcohol including the structure presented by Chemical Formula 1 was not used when the urethane acrylate compound is synthesized. In addition, the urethane acrylate compound of A-9 differs from the urethane acrylate compounds of A-1 to A-7 in that the first polyfunctional alcohol including the structure according to Chemical Formula 1 was not used and a monofunctional isocyanate was used instead of a polyfunctional isocyanate when synthesizing the urethane acrylate compound. In Table 2 below, AOI-VM is substantially a monofunctional isocyanate; however, for ease of comparison and convenience of presentation, AOI-VM is listed under the entry corresponding to the polyfunctional isocyanate used in the synthesis.

**Table 2**

| | | Synthesis Example 1 | Synthesis Example 2 | Synthesis Example 3 | Synthesis Example 4 | Synthesis Example 5 | Synthesis Example 6 | Synthesis Example 7 | Synthesis Example 8 | Synthesis Example 9 |
|---|---|---|---|---|---|---|---|---|---|---|
| | | A-1 | A-2 | A-3 | A-4 | A-5 | A-6 | A-7 | A-8 | A-9 |
| First Polyfunctional Alcohol (g) | BA-2 | 18.9 | | | | 16.2 | 10.7 | | | |
| | BA-P2M | 20.7 | | | | | | | | |
| | BA-P3U | | 21.3 | | | | | | | |
| | BA-P8 | | | 38.8 | 65.9 | | | | | |
| | BA-10 | | | | | | | 87.9 | | |
| Second Alcohol (g) | 2,2-bis(hydroxymethyl)but vric acid | 1.2 | 7.8 | 8.6 | 4.9 | 12.2 | 14.6 | 1.2 | | |
| | ethanol | 3.1 | 2.79 | 3.1 | | | | | | |
| | Nipporan 4009 | | | | | | | | 65.5 | |
| | SC-P1600 | | | | | | | | | 40.1 |
| Polyfunctional | 1,3-bis(isocyanatomethyl) cyclohexane | 32 | 29 | 32 | 32 | 32 | 32 | 32 | | |
| Isocyanate (g) | isophorone diisocyanate | | | | | | | | 20.6 | |
| | AOI-VM | | | | | | | | | 2.82 |
| Compound including at least one (meth)acr yloyl group and at least one hydroxyl group per molecule (g) | 2-hydroxyethyl acrylate | 3.8 | | | 7.6 | 7.6 | 7.6 | 5.7 | | |
| | PLACCEL FA1DDM | | 3.5 | 7.6 | | | | | 12.9 | |
| Dibutyltin Dilaurate (g) | | 0.011 | 0.011 | | 0.011 | 0.011 | 0.011 | 0.011 | 0.017 | 0.011 |
| Molecular Weight (Mw) | | 6100 | 4080 | 7800 | 11000 | 4000 | 3800 | 13000 | 10900 | 2400 |
| Molecular Weight (Mn) | | 3800 | 2540 | 5800 | 4200 | 2400 | 2200 | 5300 | 5700 | 2300 |
| Structure according to Chemical Formula 1 (% by weight) | | 50 | 33 | 43 | 60 | 24 | 16 | 69 | 0 | 0 |
| Content of First polyfunctional alcohol (% by weight) | | 49.69 | 33.08 | 43.06 | 59.69 | 23.82 | 16.49 | 69.32 | 0 | 0 |
| Content of Second alcohol (% by weight) | | 5.40 | 16.45 | 12.99 | 4.44 | 17.94 | 22.50 | 0.95 | 66.16 | 93.43 |

In Table 2, a content of the first polyfunctional alcohol and a content of the second alcohol are calculated with respect to the total weight of a reactant. Here, the term "the total weight of a reactant" refers to the sum of the amounts of compounds, each of which includes at least one first polyfunctional alcohol, at least one second alcohol, at least one polyfunctional isocyanate, at least one (meth)acryloyl group, and at least one hydroxyl group per molecule. The compounds used in Table 2 are as follows, and an amount of each component is expressed in gram (g). Additionally, the weight percentage of the structure according to Chemical Formula 1 is calculated with respect to the total weight of urethane acrylate.
BA-2: 2,2-bis(4-polyoxypropyleneoxyphenyl)ethane (Nippon Nyukazai Co., Ltd)
BA-P2M: 2,2-bis(4-polyoxypropyleneoxyphenyl)propane (Nippon Nyukazai Co., Ltd)
BA-P3U: 2,2-bis(4-polyoxypropyleneoxyphenyl)propane (Nippon Nyukazai Co., Ltd)
BA-P8: 2,2-bis(4-polyoxypropyleneoxyphenyl)propane (Nippon Nyukazai Co., Ltd)
BA-P10: 2,2-bis(4-polyoxypropyleneoxyphenyl)propane
Nipporan 4009: polyester polyol (TOSOH Corporation)
SC-P1600: polyglycerin polyether (Sakamoto Yakuhin Kogyo Co., Ltd.)
1,3-bis(isocyanatomethyl)cyclohexane: (Mitsui Chemicals, Inc.)
Isophorone diisocyanate: (TCI CO., Ltd.)
AOI-VM: 2-isocyanatoethyl acrylate (Resonac Corporation)
Dibutyltin dilaurate: (TCI CO., Ltd.)
2-hydroxyethyl acrylate: (TCI CO., Ltd.)
PLACCEL FA1DDM: caprolactone-modified acrylate (Daicel Corporation)

Table 3 below shows a viscosity of the resin composition before curing and physical properties of an adhesive member after curing. Methods for evaluating each property are as follows.

### Viscosity Measurement

The viscosity of the resin composition before curing in Examples and Comparative Examples was measured at about 25 °C according to JISK2283 method.

### Glass Transition Temperature and Storage Modulus Measurements

The glass transition temperature and storage modulus were measured using samples obtained by curing the resin compositions of Examples and Comparative Examples.

On a slide glass (manufactured by Matsunami Glass Ind., Ltd., product name: Slide glass S1112), a release-treated PET film (manufactured by PANAC Co., Ltd., product name: NP1000A), and a silicone rubber sheet (manufactured by Tigers Polymer Corporation), through which a hole having a diameter of about 8 mm was formed, were sequentially stacked. The resin compositions of Examples and Comparative Examples were each dropped in an amount of about 28 µL into the hole of the silicone rubber sheet. The dropped resin compositions of Examples and Comparative Examples were irradiated with ultraviolet light using a UVLED lamp having a peak at about 365 nm and about 385 nm such that the amount of light provided to the dropped resin compositions of Examples and Comparative Examples reached about 1000 mJ/cm² and about 520 mJ/cm², respectively. Through this process, measurement samples having a diameter of about 8 millimeters (mm) and a thickness of about 500 micrometer (µm) were obtained. After curing of the measurement sample manufactured using a dynamic viscoelasticity meter (manufactured by Anton Paar Japan K.K, product name: MCR302), a glass transition temperature Tg and a storage modulus at about 25°C were measured.

The glass transition temperature Tg and the storage modulus were measured under the condition that a frequency is about 1 Hz and a temperature rising rate is about 2 °C/min (degrees Celsius per minute) from about -30 °C to about 80 °C.

### 180° Peeling Strength Measurement of Adhesive Member

The resin composition was applied on a soda-lime glass having a size of about 26 mm x about 76 mm (manufactured by Central Glass Co., Ltd.) by using an inkjet printer so as to have a thickness of about 100 µm. Subsequently, the resin composition was irradiated with the ultraviolet light so as to have an accumulated light quantity of about 1000 mJ/cm² and about 520 mJ/ cm^{2 ₂} by using a UV-LED lamp having peaks at wavelengths of about 365 nanometers (nm) and about 385 nm, respectively. Afterwards, a PET film (manufactured by Toyobo Co., Ltd., product name: A4360, and thickness: about 50 µm) cut to a size of about 20 mm x about 150 mm was bonded to the soda lime glass irradiated with ultraviolet light by being applied with a pressure of about 0.15 MPa, and a sample was obtained.

A peeling strength of the obtained sample was measured using a universal testing machine (manufactured by Instron Corporation, product type: 5965) at a rate of about 300 mm per minute at temperature of about 25 °C and about 60 °C so as to have a peeling angle of about 180°. The peeling strength was measured three times, an average peeling value of about 50 mm was calculated, and then the obtained value was multiplied by about 1.25 to evaluate the peeling strength.

**Table 3**

| | Example | | | | | | | Comparative Example | | | | | | |
|---|---|---|---|---|---|---|---|---|---|---|---|---|---|---|
| | 1 | 2 | 3 | 4 | 5 | 6 | 7 | 1 | 2 | 3 | 4 | 5 | 6 | 7 |
| Viscosity at 25°C (mPa·s) | 9 | 17.3 | 12.9 | 13.8 | 12.2 | 11. 3 | 18.3 | 16.6 | 21 | 6.8 | 12. 2 | 14 | 10.3 | 19.5 |
| 180° peeling strength at 25°C (gf/25m m) | 2560 | 3360 | 3500 | 3550 | 3000 | 2100 | 2200 | 28 | 484 | 407 | 1200 | 500 | 1300 | 1800 |
| 180° peeling strength at 60°C | 344 | 330 | 590 | 580 | 450 | 300 | 350 | 26 | 50 | 22 | 200 | 800 | 200 | 300 |
| (gf/25m m) | | | | | | | | | | | | | | |
| Tg (°C) | 14.2 | -2.1 | -2.6 | 1.5 | 1.8 | -5.2 | -1.7 | -20 | 1.15 | 28.5 | 6.7 | -4.2 | -6.3 | 1.5 |
| Storage Modulus 25°C (MPa) | 0.033 | 0.08 | 0.085 | 0.092 | 0.1 | 0.06 | 0.073 | 0.087 | 0.072 | 0.016 | 0.22 | 0.061 | 0.101 | 0.101 |

Referring to Table 3, it may be confirmed that after curing, the resin compositions of Examples 1 to 7 have a 180° peeling strength of about 2000 gf/25 mm to about 5000 gf/25 mm, as measured at about 25 °C on a glass substrate, and a 180° peeling strength of about 250 gf/25 mm to about 1000 gf/25 mm, as measured at about 60 °C on a glass substrate. In contrast, after curing, all the resin compositions of Comparative Examples 1 to 7 have a significantly low 180° peeling strength when measured at about 25 °C and about 60 °C.

The resin compositions of Examples 1 to 7 have a viscosity of about 5 mPa·s to about 20 mPa·s, which is measured at 25 °C before curing, and thus an excellent coatability may be exhibited.

The resin compositions of Examples 1 to 7 have a glass transition temperature Tg of about -20°C to about 20°C after curing, and thus an adhesive strength as well as a durability may be appropriately achieved. In contrast, in Comparative Example 3, when the resin composition has the glass transition temperature Tg of less than about -20°C after curing, the adhesive strength is significantly low.

Additionally, the resin compositions of Examples 1 to 7 have a storage modulus of about 0.02 MPa to about 0.2 MPa, which is measured at about 25 °C after curing, and thus an adhesive strength as well as a flexibility may be appropriately achieved. In contrast, Comparative Example 4 has a storage modulus is greater than about 0.2 Mpa after curing, all the adhesive strengths at both room temperature and high temperature are significantly less than Examples 1 to 7.

A resin composition according to an embodiment may have a low viscosity before curing and have an increased adhesive strength after curing.

An adhesive member formed of a resin composition according to an embodiment may exhibit an excellent adhesion reliability.

An electronic apparatus according to an embodiment may include the adhesive member formed of the resin composition according to an embodiment, thereby exhibiting an excellent reliability.

A resin composition according to an embodiment may have a low viscosity before curing, allow for short-time curing, and exhibit a high adhesive strength at room temperature and also at a high temperature after curing.

An adhesive member according to an embodiment may exhibit an excellent adhesion reliability.

An electronic apparatus according to an embodiment may include the adhesive member according to an embodiment, thereby exhibiting an excellent reliability.

In the above, description has been made with reference to embodiments of the inventive concept, but those skilled or of ordinary skill in the art may understand that various modifications and changes may be made to the inventive concept insofar as such modifications and changes do not depart from the technical scope of the inventive concept set forth in the claims to be described later.

Therefore, the technical scope of the inventive concept is not to be limited to the contents stated in the detailed description of the specification, but should be determined by the claims.

## Claims

1. A resin composition comprising:
a urethane acrylate compound including a structure according to Chemical Formula 1;
a monomer having one polymerizable unsaturated group per molecule; and
a photopolymerization initiator,
wherein an amount of the urethane acrylate compound is about 5% by weight to about 18% by weight based on the total weight of the resin composition; and
wherein an amount of the structure according to Chemical Formula 1 in the urethane acrylate compound is about 20% by weight to about 60% by weight based on the total weight of the urethane acrylate compound, 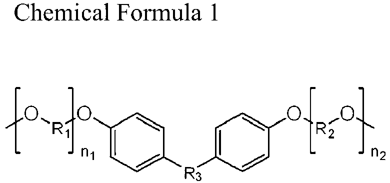
where, in Chemical Formula 1,
R₁ and R₂ are each independently a substituted or unsubstituted alkylene group having 1 to 4 carbon atoms,
R₃ is a substituted or unsubstituted alkylene group having 1 to 3 carbon atoms, and
n₁ and n₂ are each independently an integer of 1 to 6.

2. The resin composition of claim 1, wherein the resin has a 180° peeling strength of about 2000 gf/25 mm to about 5000 gf/25 mm as measured at about 25 °C on a glass substrate after photocuring in air under an ultraviolet accumulated light quantity that is less than about 2000 mJ/cm².

3. The resin composition of claim 1 or claim 2, wherein the resin has a 180° peeling strength of about 250 gf/25 mm to about 1000 gf/25 mm as measured at about 60 °C on a glass substrate after photocuring in air under an ultraviolet accumulated light quantity that is less than about 2000 mJ/cm².

4. The resin composition of any one of claims 1 to 3, wherein the urethane acrylate compound is synthesized from a reactant comprising a first polyfunctional alcohol including the structure according to Chemical Formula 1, a second alcohol different from the first polyfunctional alcohol, a polyfunctional isocyanate-based compound, and a compound having at least one (meth)acryloyl group and at least one hydroxyl group per molecule.

5. The resin composition of claim 4, wherein the second alcohol comprises 2,2-bis(hydroxymethyl)butyric acid.

6. The resin composition of claim 4 or claim 5, wherein the polyfunctional isocyanate-based compound comprises 1,3-bis(isocyanatomethyl)cyclohexane.

7. The resin composition of any one of claims 1 to 6, wherein the polymerizable unsaturated group of the monomer is an acrylate group.

8. The resin composition of any one of claims 1 to 7, wherein the monomer comprises at least one of 4-hydroxybutyl acrylate, tetrahydrofurfuryl acrylate, isobornyl acrylate, isodecyl acrylate, dicyclopentenyl acrylate, lauryl acrylate (C12), 2-ethylhexyl acrylate, and 2-{2-[(2-ethylhexyl)oxy]ethoxy}ethyl acrylate.

9. The resin composition of any one of claims 1 to 8, wherein:
(i) an amount of the monomer is about 50% by weight to about 93% by weight based on the total weight of the resin composition; and/or
(ii) the urethane acrylate compound has a weight-average molecular weight of about 3000 grams per mole to about 15000 grams per mole.

10. The resin composition of any one of claims 1 to 9, wherein:
(i) the photopolymerization initiator comprises at least one of bis(2,4,6-trimethylbenzoyl)phenylphosphine oxide, α-hydroxy alkyl phenone, ethyl(2,4,6-trimethylbenzoyl)phenyl phosphinate, and 1-hydroxy cyclohexyl-phenylketone; and/or
(ii) the resin composition is configured to be provided through an inkjet printing method or a dispensing method.

11. An adhesive member comprising a polymer derived from a resin composition,
wherein the resin composition comprises a urethane acrylate compound including a structure according to Chemical Formula 1, a monomer having one polymerizable unsaturated group per molecule, and a photopolymerization initiator,
wherein an amount of the urethane acrylate compound is about 5% by weight to about 18% by weight based on the total weight of the resin composition, and
wherein an amount of the structure according to Chemical Formula 1 in the urethane acrylate compound is about 20% by weight to about 60% by weight based on the total weight of the urethane acrylate compound, 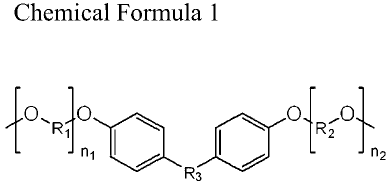
where, in Chemical Formula 1,
R₁ and R₂ are each independently a substituted or unsubstituted alkylene group having 1 to 4 carbon atoms,
R₃ is a substituted or unsubstituted alkylene group having 1 to 3 carbon atoms, and
n₁ and n₂ are each independently an integer of 1 to 6.

12. The adhesive member of claim 11, wherein:
(i) the polymer has a 180° peeling strength about 2000 gf/25 mm to about 5000 gf/25 mm as measured at about 25 °C on a glass substrate; and/or
(ii) the polymer has a 180° peeling strength about 250 gf/25 mm to about 1000 gf/25 mm as measured at about 60 °C on a glass substrate.

13. An electronic apparatus (EA) comprising: a display device (DD) configured to provide an image; and
an adhesive member (AP) included in the display device (DD), and including a polymer derived from a resin composition,
the resin composition comprises a urethane acrylate compound including a structure according to Chemical Formula 1, a monomer having one polymerizable unsaturated group per molecule, and a photopolymerization initiator,
an amount of the urethane acrylate compound is about 5% by weight to about 18% by weight based on the total weight of the resin composition, and
an amount of the structure according to Chemical Formula 1 in the urethane acrylate compound is about 20% by weight to about 60% by weight based on the total weight of the urethane acrylate compound, 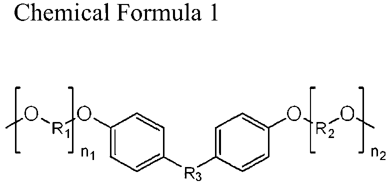
where, in Chemical Formula 1,
R₁ and R₂ are each independently a substituted or unsubstituted alkylene group having 1 to 4 carbon atoms,
R₃ is a substituted or unsubstituted alkylene group having 1 to 3 carbon atoms, and
n₁ and n₂ are each independently an integer of 1 to 6.

14. The electronic apparatus (EA) of claim 13, wherein:
(i) the adhesive member (AP) has a 180° peeling strength of about 2000 gf/25 mm to about 5000 gf/25 mm as measured at about 25 °C on a glass substrate, and
a 180° peeling strength of about 250 gf/25 mm to about 1000 gf/25 mm as measured at about 60 °C on a glass substrate; and/or
(ii) the display device (DD) comprises a display module (DM) and a window (WP), and
the adhesive member (AP) is disposed between the display module (DM) and the window (WP), optionally wherein the window (WP) comprises a base layer (BL) and a printed layer (BM) disposed between the adhesive member (AP) and the base layer (BL), and
the resin composition provided on one surface of the display module (DM) or one surface of the window (WP) is cured by being irradiated with light which passes through the printed layer (BM), and the adhesive member (AP) is formed.

15. The electronic apparatus (EA) of claim 13 or claim 14, wherein the display device (DD) comprises a display module (DM), a processor (PR), a memory (MR), and a power module (PM).
